(19) Europäisches Patentamt
European Patent Office
Office européen des brevets

(11) EP 3 165 554 A1

(12) **EUROPEAN PATENT APPLICATION**
published in accordance with Art. 153(4) EPC

(43) Date of publication:
**10.05.2017 Bulletin 2017/19**

(21) Application number: **14896816.7**

(22) Date of filing: **02.07.2014**

(51) Int Cl.:
***C08G 69/26*** $^{(2006.01)}$ ***C08L 77/06*** $^{(2006.01)}$

(86) International application number:
**PCT/JP2014/003517**

(87) International publication number:
**WO 2016/001949 (07.01.2016 Gazette 2016/01)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Toyo Ink SC Holdings Co., Ltd.**
**Tokyo 104-8377 (JP)**

(72) Inventors:
- **OGIWARA, Naoto**
  **Tokyo 104-8377 (JP)**
- **SAKAGUCHI, Go**
  **Tokyo 104-8377 (JP)**
- **KOBAYASHI, Hidenobu**
  **Tokyo 104-8379 (JP)**
- **MATSUDO, Kazunori**
  **Tokyo 104-8379 (JP)**
- **KISHI, Daisuke**
  **Tokyo 104-8377 (JP)**

(74) Representative: **Pfenning, Meinig & Partner mbB**
**Patent- und Rechtsanwälte**
**Theresienhöhe 11a**
**80339 München (DE)**

(54) **HEAT-CURABLE RESIN COMPOSITION, POLYAMIDE, ADHESIVE SHEET, CURED ARTICLE, AND PRINTED WIRING BOARD**

(57) A thermosetting resin composition excellent in dimensional stability during curing and adhesiveness, heat resistance, moist heat resistance, electrical insulating properties, flexibility, low dielectric properties and low dissipation factor properties after curing is provided.

A thermosetting resin composition according to the present invention is a thermosetting resin composition containing a polyamide (A) made by polymerization of a polybasic acid monomer and a polyamine monomer and having a phenolic hydroxyl group on a side chain, and a compound (B) with a functionality of three or more that can react with the phenolic hydroxyl group. Monomers that form the polyamide (A) include a monomer having a phenolic hydroxyl group and a monomer having a hydrocarbon group with a carbon number of 20 to 60 (excluding an aromatic ring to which the phenolic hydroxyl group bonds) and having a cyclic structure with a carbon number of 5 to 10.

EP 3 165 554 A1

Printed by Jouve, 75001 PARIS (FR)

## Description

### Technical Field

The present invention relates to a thermosetting resin composition and a polyamide containing a phenolic hydroxyl group (A-1). Further, the present invention relates to an adhesive sheet and a cured material formed from the thermosetting resin composition. Furthermore, the present invention relates to a printed-wiring board including a layer made of the cured material.

### Background Art

Polyamides have fine characteristics, such as mechanical characteristics, electrical characteristics, chemical resistance, moldability and processability, soldering heat resistance and the like and are widely used for engineering plastic in a variety of areas including automotive parts and electrical and electronic parts based on its fine characteristics. For example, crystalline polyamides such as Nylon (registered trademark) 6 and Nylon 66 are widely used as fibers for clothing and fibers for industrial materials based on its good mechanical characteristics, moldability and processability.

However, general-purpose polyamides have a high amide bond concentration and have high moisture absorption properties resulting from the amide bond. Therefore, it is pointed out that products using general-purpose polyamides have problems of changes in physical properties, degradation in acid, hot alcohol and hot water, oxidation degradation and the like. Further, because the amide bond causes an increase in cohesive force, poor solubility to a commonly used solvent is also pointed out.

In order to obtain polyamides which meets such a higher requirement, such as polyamides conjugated or blended with various types of resin have been studied, and also many studies on controlling polyamide structure have been reported.

For example, Patent Literatures 1 and 2 disclose an epoxy-terminated polyamide made by reaction of a carboxylic acid-terminated polyamide and an epoxy compound.

Patent Literature 3 discloses modified polyimide obtained by reaction of an epoxy-terminated polyamide and an acid anhydride compound.

Patent Literatures 4 to 7 disclose an adhesive composition made of a polyamide containing a polybasic acid with a carbon number of 36 as an essential ingredient, and epoxy resin and phenolic resin.

Patent Literature 8 discloses an adhesive film containing solvent-soluble polyamide resin and two types of epoxy resin.

Patent Literature 9 discloses an adhesive composition containing polyester amide resin where a phenolic hydroxyl group is introduced to the resin.

Patent Literature 10 discloses a rubber-modified polyamide to which a phenolic hydroxyl group is introduced.

Patent Literature 11 discloses a cured film of a composition where epoxy resin and phenolic resin are added in equal parts or more to modified polyamide resin made by reaction of an unmodified polyamide and resol phenolic resin as an adhesive tape for TAB.

### Citation List

#### Patent Literature

Patent Literature 1: Japanese Unexamined Patent Publication No. H11-228932
Patent Literature 2: Japanese Unexamined Patent Publication No. H5-295342
Patent Literature 3: WO1999/57170
Patent Literature 4: Japanese Unexamined Patent Publication No. H6-181239
Patent Literature 5: Japanese Unexamined Patent Publication No. H11-260864
Patent Literature 6: Japanese Unexamined Patent Publication No. H6-338681
Patent Literature 7: Japanese Unexamined Patent Publication No. H6-322348
Patent Literature 8: Japanese Unexamined Patent Publication No. H10-183076
Patent Literature 9: Japanese Unexamined Patent Publication No. 2006-152015
Patent Literature 10: International Patent Publication No. 2007/052523
Patent Literature 11: Japanese Unexamined Patent Publication No. H9-115966

## Summary of Invention

### Technical Problem

The inventions described in Patent Literatures 1 and 2 have an advantage that the adhesive force after curing is improved because of using an epoxy-terminated polyamide having high compatibility with epoxy resin; however, it has a problem that it is difficult to obtain high crosslink density after curing because a secondary hydroxyl group of a side-chain cross-linking site has a poor curing property.

The invention described in Patent Literature 3 has an advantage that high crosslink density after curing is obtained because a side-chain cross-linking site is a carboxyl group; however, it has a problem that the insulation reliability under a high-temperature moisture condition is poor.

The invention described in Patent Literatures 4 to 8 has a workability problem that a thermosetting resin composition frequently extrudes during heat curing.

Because the polyester amide resin described in Patent Literature 9 has too many ester bonds, there is a problem that a cured coating after being placed under a high temperature and high humidity environment is poor in basic properties for an insulating material of a typical electrical circuit board, such as insulating properties and chemical resistance.

The polyamide resin described in Patent Literature 10 has a problem that, by oxidation originated from a butadiene backbone, gelation occurs due to intramolecular crosslinking and the preservation stability of the composition significantly deteriorates. Further, because molecules tend to be aligned due to its butadiene backbone and highly crystallized, the resin has a poor solubility and a dielectric constant or the like which is hard to decrease.

In Patent Literature 11, three resins: modified polyamide resin, epoxy resin and phenolic resin synergistically exerts great effect on high-temperature insulating properties and heat-resistant deformation properties. However, it has a problem in flexibility. Further, the modified polyamide resin has a productivity problem that it requires a purification process, because an unreacted substrate is likely to remain or various kinds of by-products are likely to be generated during the modification process.

An object of the present invention is to provide a thermosetting resin composition excellent in dimensional stability during curing process and adhesiveness, heat resistance, moist heat resistance, electrical insulating properties, flexibility, low dielectric properties and low dissipation factor properties after curing process.

### Solution to Problem

The inventors of the present invention have conducted extensive studies to solve the above-described problems and, as a result, found that a specific phenolic hydroxyl group-containing polyamide can solve the above problems. The inventors also found that the following aspects of the present invention can solve the problems and thereby accomplished the present invention.

[1] A thermosetting resin composition containing a polyamide (A) made by polymerization of a polybasic acid monomer and a polyamine monomer and having a phenolic hydroxyl group on a side chain, and a compound (B) with a functionality of three or more that can react with the phenolic hydroxyl group, wherein
the polyamide (A) satisfies (i) and/or (ii) and further satisfies (iii) to (vi) below, and
the compound (B) satisfies (vii) below:

(i) the polyamide (A) is a polyamide (A-1) containing, in the same polymer, the phenolic hydroxyl group and a hydrocarbon group with a carbon number of 20 to 60 (The carbon number excludes an aromatic ring to which the phenolic hydroxyl group bonds. The range includes upper and lower limit and similarly in the following.),
(ii) the polyamide (A) is a polyamide (A-3) being a mixture of a polyamide (a-1) containing a phenolic hydroxyl group on a side chain and a polyamide (a-2) containing a hydrocarbon group with a carbon number of 20 to 60,
(iii) monomers that form the polyamide (A-1) include a monomer having a phenolic hydroxyl group and a monomer having a hydrocarbon group with a carbon number of 20 to 60,
(iv) the polybasic acid monomer or/and the polyamine monomer that form the polyamide (a-1) include a monomer having a phenolic hydroxyl group, and the polybasic acid monomer and the polyamine monomer do not include a monomer having a hydrocarbon group with a carbon number of 20 to 60,
(v) the polybasic acid monomer or/and the polyamine monomer that form the polyamide (a-2) include a monomer having a hydrocarbon group with a carbon number of 20 to 60, and the polybasic acid monomer and the polyamine monomer do not include a monomer having a phenolic hydroxyl group,
(vi) at least a part of monomers having a hydrocarbon group with a carbon number of 20 to 60 includes a compound having a cyclic structure with a carbon number of 5 to 10, and
(vii) the compound (B) is at least one selected from a group consisting of an epoxy group-containing compound,

an isocyanate group-containing compound, a carbodiimide group-containing compound, metal chelate, metal alkoxide and metal acylate.

[2] A polyamide (A-1) made by polymerization of a polybasic acid monomer and a polyamine monomer and having a phenolic hydroxyl group on a side chain, wherein
the phenolic hydroxyl group and a hydrocarbon group with a carbon number of 20 to 60 (excluding an aromatic ring to which the phenolic hydroxyl group bonds) are contained in the same polymer, and
the polyamide (A-1) is made by polymerization of monomers including a monomer having a phenolic hydroxyl group and a monomer having a hydrocarbon group with a carbon number of 20 to 60 and having a cyclic structure with a carbon number of 5 to 10.
[3] An adhesive sheet formed from the above-described thermosetting resin composition.
[4] A cured material obtained by heat curing the above-described thermosetting resin composition.
[5] The above-described cured material wherein a glass-transition temperature is -40° to 150°C.
[6] A printed-wiring board comprising a layer made of the above-described cured material arranged on a substrate.

Advantageous Effects of Invention

Use the specific phenolic hydroxyl group-containing polyamide (A) provides a thermosetting resin composition excellent in dimensional stability during curing process and adhesiveness, heat resistance, moist heat resistance, electrical insulating properties, flexibility, low dielectric properties and low dissipation factor properties after curing process.

**Description of Embodiments**

A thermosetting resin composition according to the present invention contains a polyamide (A) containing a phenolic hydroxyl group on the side chain (which is also referred to hereinafter as "phenolic hydroxyl group-containing polyamide (A)") and a compound (B) with a functionality of three or more that can react with the above-described phenolic hydroxyl group (which is also referred to hereinafter as "compound (B)"). Polyamide (A) is generally synthesized by using, as monomers, a polybasic acid compound with a valency of two or more selected from polybasic acid and/or acid anhydride and/or their lower alkyl ester and a polyamine compound with a valency of two or more, but a synthesis method of the polyamide (A) is not limited. The phenolic hydroxyl group in the polyamide (A) can form a cross-linked structure by heat curing with the compound (B) having a functionality of three or more.

<Phenolic hydroxyl group-containing polyamide (A)>

The polyamide (A) according to the present invention satisfies (i) a polyamide (A-1) containing, in the same polymer, a phenolic hydroxyl group and a hydrocarbon group with a carbon number of 20 to 60 (note that, however, excluding an aromatic ring to which the phenolic hydroxyl group bonds) and/or (ii) a polyamide (A-3) being a mixture of a polyamide (a-1) containing a phenolic hydroxyl group on the side chain and a polyamide (a-2) containing a hydrocarbon group with a carbon number of 20 to 60 (note that, however, excluding an aromatic ring to which the phenolic hydroxyl group bonds). The former polyamide (A-1) is preferred for use in terms of the solubility to a commonly used solvent and the productivity. Although the note within the parentheses in "a hydrocarbon group with a carbon number of 20 to 60 (note that, however, excluding an aromatic ring to which the phenolic hydroxyl group bonds) " is omitted in the following description, it is assumed that "a hydrocarbon group with a carbon number of 20 to 60" in the following description satisfies the condition described in the note. Further, "a hydrocarbon group with a carbon number of 20 to 60" is also referred to as "a C20-60 hydrocarbon group". Furthermore, a hydrocarbon group with a carbon number of 20 to 60 indicates a hydrocarbon group with a carbon number of 20 to 60 contained as all or a part of residues other than functional groups which contribute to the polymerization of monomers, and the number of carbons is counted in a continuous structure where elements other than carbon and hydrogen are not contained. It is more preferred that all of residues other than functional groups which contribute to the polymerization of monomers are hydrocarbon groups with a carbon number of 20 to 60. In other words, it is the total number of carbons in successive hydrocarbon groups including a main chain and a side chain that is directly bonded to the main chain for the obtained polyamide (A-1), and an aromatic ring, in addition to an aliphatic (including alicyclic), are counted. Note that, however, an aromatic ring to which a phenolic hydroxyl group is bonded is not included. Further, hydrocarbon groups that are bonded through an aromatic ring to which a phenolic hydroxyl group is bonded are counted as different hydrocarbon groups.
The polyamide (A) satisfies the following (iii) to (vi). Specifically,

(iii) It contains, as monomers that form the polyamide (A-1), a monomer having a phenolic hydroxyl group and a monomer having a hydrocarbon group with a carbon number of 20 to 60. Note that a monomer having a phenolic

hydroxyl group and a hydrocarbon group with a carbon number of 20 to 60 in the same type of monomers may be used as a matter of course.

(iv) A polybasic acid monomer or/and a polyamine monomer that form the polyamide (a-1) include a monomer having a phenolic hydroxyl group, and a polybasic acid monomer and a polyamine monomer do not include a monomer having a hydrocarbon group with a carbon number of 20 to 60.

(v) A polybasic acid monomer or/and a polyamine monomer that form the polyamide (a-2) include a monomer having a hydrocarbon group with a carbon number of 20 to 60, and a polybasic acid monomer and a polyamine monomer do not include a monomer having a phenolic hydroxyl group.

(vi) A monomer having a hydrocarbon group with a carbon number of 20 to 60 include a compound having a cyclic structure with a carbon number of 5 to 10. "include a compound having a cyclic structure with a carbon number of 5 to 10" means that monomers having a cyclic structure with a carbon number of 5 to 10 are included in at least a part of monomers having a hydrocarbon group with a carbon number of 20 to 60.

A monomer having a hydrocarbon group with a carbon number of 20 to 60 are preferably a monomer having a hydrocarbon group with a carbon number of 24 to 56, more preferably a monomer having a hydrocarbon group with a carbon number of 28 to 48, and still more preferably a monomer having a hydrocarbon group with a carbon number of 36 to 44, in order to effectively bring out the solubility and the flexibility.

By using the polyamide (A) of (i) or/and (ii), it is possible to form a cured material having high moist heat resistance and flexibility from the thermosetting resin composition without deterioration of the original heat resistance and chemical resistance of a polyamide. There is also an advantage that it is possible to provide a thermosetting resin composition that can be used for a variety of commonly used organic solvent.

To be more specific, it is possible to considerably improve the physical properties that are significantly important as an adhesive and a coating agent to be used for electronic materials like a printed-wiring board, such as dimensional stability during hot press, adhesiveness to a copper or a polyamide substrate, heat resistance during solder reflow, flexibility when folding a printed-wiring board, electrical insulating properties to prevent touch leakage of a narrow-pitch wiring circuit, and a dielectric constant and a dissipation factor that are important for an adhesive and a coating agent to be used for a printed-wiring board through which high-frequency electrical signals propagate. This can be achieved by the following reasons.

The first reason is that, by using a monomer having a phenolic hydroxyl group as monomers that form the polyamide (A) and introducing a functional group (phenolic hydroxyl group) that serves as a cross-linking point on the side chain of a main chain backbone, it is possible to improve the crosslink density by heat curing and thereby improve the dimensional stability during hot press and the heat resistance during solder reflow. Concerning the phenolic hydroxyl group on the side chain, it is important to use as a material of the polyamide (A), a polybasic acid compound (polybasic acid monomer) having a phenolic hydroxyl group or/and a polyamine compound (polyamine monomer) having a phenolic hydroxyl group as described later.

The second reason is that, by introduction of a C20-60 hydrocarbon group, the concentration of an amide bond which increase moisture absorption rate can be relatively lowered, and it is thereby possible to improve the insulation reliability and the dielectric properties. The third reason is that, by the softness originated from a C20-60 hydrocarbon group, and by introduction of a phenolic hydroxyl group in monomers that form the polyamide (A), it is possible to improve the flexibility. Thus, this can be suitably used for a printed-wiring board or the like for which folding properties or the like are required.

Use of butadiene as disclosed in Patent Literature 10 causes a problem of the high crystallinity and the poor solubility. On the other hand, by adding a compound having a cyclic structure with a carbon number of 5 to 10 as a monomer having a C20-60 hydrocarbon group, it is possible to disrupt the alignment of molecules and deteriorate the crystallinity. As a result, it is possible to improve the solubility. Further, because a compound having a cyclic structure with a carbon number of 5 to 10 has a structure that contains a hydrocarbon group such as an alkyl group in a chain form or the like with a high degree of freedom and high hydrophobicity in a part other than the cyclic structure, it is possible to more effectively increase the solubility and effectively reduce a dielectric constant and a dissipation factor. C20 to C60 hydrocarbon group can be introduced by using a polybasic acid compound having a C20 to C60 hydrocarbon group or/and a polyamine compound having a C20 to C60 hydrocarbon group as materials of the polyamide (A) as described later.

In the case where a polyamide to which a structure having a C20 to C60 hydrocarbon group is incorporated, instead of a phenolic hydroxyl group on the side chain is incorporated, is used as the polyamide, polyamide with high insulation reliability, dielectric properties and adhesion to a substrate is obtained by reduction of the amide bond concentration and addition of the softness and flexibility. However, because a cross-linking point exists only at the terminal of a main chain, there is a long distance between cross-linking points in a cured material. As a result, the dimensional stability during hot press is deteriorated and the insulation reliability is also deteriorated under severe conditions such as high-temperature and humidity, and further higher heat resistance and moist heat resistance such as tested in a

solder reflow test at high-temperature and a solder test in a humidified state cannot be satisfied.

Further, in the case where polyamide that introduces a structure having a phenolic hydroxyl group, without introducing a C20 to C60 hydrocarbon group, is used as the polyamide, the higher heat resistance and the dimensional stability during hot press can be obtained because the crosslink density is improved. However, in such a polyamide, the amide bond concentration is too nigh, and the polyamide and the thermosetting resin composition containing the polyamide is difficult to dissolve in a commonly used organic solvent and the hygroscopicity increases. As a result, higher moist heat resistance such as tested in a solder test in a humidified state is deteriorated, and it is difficult to obtain good dielectric constant and dissipation factor properties that are important for an adhesive and a coating agent to be used for a printed-wiring board through which high-frequency electrical signals propagate.

On the other hand, the phenolic hydroxyl group-containing polyamide (A) according to the present invention which has two structures with a phenolic hydroxyl group and a C20-60 hydrocarbon group, and is thereby possible to dissolve in a commonly used organic solvent, can improve the dimensional stability during hot press and reduce a dielectric constant and a dissipation factor, and further solve the tradeoff between the adhesiveness and the heat resistance and the tradeoff between the flexibility and the electrical insulating properties. A preferred embodiment of the polyamide (A-1) and (A-3) is described hereinafter in detail.

<<Polyamide (A-1)>>

The polyamide (A-1) is made by polymerization of a polybasic acid monomer ($m_1$) and a polyamine monomer ($m_2$), having a phenolic hydroxyl group on the side chain and having a phenolic hydroxyl group and a C20-60 hydrocarbon group in the same polymer. As long as the above-described conditions are satisfied, a polybasic acid monomer and a polyamine monomer having another structure may be appropriately used in the scope of the spirit of the present invention.

Specifically, the polybasic acid monomer ($m_1$) may be at least one selected from a group consisting of a polybasic acid compound having a phenolic hydroxyl group, a polybasic acid compound having a C20-60 hydrocarbon group and other polybasic acid compounds, and the polyamine monomer ($m_2$) may be at least one selected from a group consisting of a polyamine compound having a phenolic hydroxyl group, a polyamine compound having a C20-60 hydrocarbon group and other polyamine compounds, so that the phenolic hydroxyl group and the C20-60 hydrocarbon group are contained in the polymer.

The phenolic hydroxyl group-containing polyamide (A-1) can be obtained by polymerizing the polybasic acid monomer ($m_1$) and the polyamine monomer ($m_2$) which are selected so as to obtain the polyamide (A-1) containing a compound having a C20-60 hydrocarbon group and a compound having a phenolic hydroxyl group in the same monomer or in different monomers.

"Containing ... in the same monomer" means that a polybasic acid compound having a phenolic hydroxyl group and a polybasic acid compound having a C20-60 hydrocarbon group may be used as the polybasic acid monomer ($m_1$), or a polyamine compound having a phenolic hydroxyl group and a polyamine compound having a C20-60 hydrocarbon group may be used as the polyamine monomer ($m_2$).

On the other hand, "Containing ...in different monomers" means that a polybasic acid compound having a phenolic hydroxyl group and a polyamine compound having a C20-60 hydrocarbon group may be used as the polybasic acid monomer ($m_1$) and the polyamine monomer ($m_2$), respectively, or a polybasic acid compound having a C20-60 hydrocarbon group and a polyamine compound having a phenolic hydroxyl group may be used as the polybasic acid monomer ($m_1$) and the polyamine monomer ($m_2$), respectively.

In any case, other polybasic acid compounds and other polyamine compounds may be used as appropriate.

Besides a main chain generated by the polymerization of the polybasic acid monomer ($m_1$) and the polyamine monomer ($m_2$), a phenolic hydroxyl group introduced to the side chain serves as a cross-linking point. Specifically, a tight cross-linked structure can be formed by heat curing the polyamide (A-1) and the compound (B) with a functionality of three or more that can react to a phenolic hydroxyl group, which is described later. As a result, the excellent dimensional stability is obtained even in the process of cross-linking during hot press, and the heat resistance during soldering after heat curing is improved.

Further, the C20-60 hydrocarbon group has a function of reducing the concentration of an amide bond with high moisture absorption property and imparting or enhancing the softness and flexibility. The moisture absorption property of a cured material after heat curing thereby deteriorates, and it is thereby possible to improve the moist heat resistance and achieve a lower dielectric constant and a lower dissipation factor, which are important factors in a printed-wiring board through which high-frequency electrical signals propagate.

The polybasic acid compound as the polybasic acid monomer ($m_1$) and the polyamine compound as the polyamine monomer ($m_2$) may be monomers with a valency of two or more, and monomers with a valency of three or more may be used as appropriate. Monomers with a valency of two and monomers with a valency of three or more may be combined to introduce a branching structure and adjust an appropriate molecular weight. Further, monomers with a valency of 1 may be used to maintain an appropriate molecular weight. By partly containing monomers with a valency

of three or more, a cohesive force can be increased. Monomers with a valency of three or more is preferably 0.1 to 20 mol% and more preferably 1 to 10 mol% in all monomers.

The polyamide (A) obtained by using dibasic acid monomers and diamine monomers has a structural unit of the following general formula (1).

General formula (1)

$$\left[ -\underset{\underset{O}{\|}}{C}-R_1-\underset{\underset{O}{\|}}{C}-\underset{\underset{H}{|}}{N}-R_2-\underset{\underset{H}{|}}{N}- \right]$$

In the general formula (1), $R_1$ is a divalent linking group which is a polybasic acid compound residue where each structural unit may have an independent structure, $R_2$ is a divalent linking group which is a polyamine compound residue where each structural unit may have an independent structure, and at least one of $R_1$ and $R_2$ contains a linking group having a phenolic hydroxyl group, and at least one of $R_1$ and $R_2$ contains a linking group having a C20-60 hydrocarbon group.

The polyamide (A-1) has a structure in which at least the structural unit represented by -CO-$R_1$-CO-NH-$R_2$-NH- is repeated at least twice. Note that a compound which has one structural unit of the polyamide (A-1) and whose terminal is blocked may be contained in the thermosetting resin composition in the scope of the spirit of the present invention.

The phenolic hydroxyl group-containing monomer and the C20-60 hydrocarbon group-containing monomer may be contained in at least one of the dibasic acid compound and the diamine compound, and those groups may be contained in both of the dibasic acid compound and the diamine compound. For example, in the case of using two types of dibasic acid compounds $R_{1-1}$ and $R_{1-2}$ and two types of diamine compounds $R_{2-1}$ and $R_{2-2}$, the structural unit of -CO-$R_{1-1}$-CO-NH-$R_{2-1}$-NH-, -CO-$R_{1-1}$-CO-NH-$R_{2-2}$-NH-, -CO-$R_{1-2}$-CO-NH-$R_{2-1}$-NH- and -CO-$R_{1-2}$-CO-NH-$R_{2-2}$-NH- can be contained.

<Polybasic acid monomer ($m_1$)>

[Polybasic acid compound having phenolic hydroxyl group]

Although the polybasic acid compound having a phenolic hydroxyl group according to the present invention is not particularly limited, examples include:

Hydroxyisophthalic acid such as 2-hydroxyisophthalic acid, 4-hydroxyisophthalic acid and 5-hydroxyisophthalic acid
Dihydroxyisophthalic acid such as 2,5-Dihydroxyisophthalic acid, 2,4-Dihydroxyisophthalic acid and 4,6-Dihydroxyisophthalic acid 2-Hydroxyterephthalic acid
Dihydroxyterephthalic acid such as 2,3-dihydroxyterephthalic acid and 2,6-dihydroxyterephthalic acid,
Hydroxyphthalic acid such as 4-hydroxyphthalic acid and 3-hydroxyphthalic acid, and
Dihydroxyphthalic acid such as 3,4-dihydroxyphthalic acid, 3,5-dihydroxyphthalic acid, 4,5-dihydroxyphthalic acid and 3,6-dihydroxyphthalic acid.

Other examples include their acid anhydride or ester derivative such as polybasic acid methyl ester. Only a difference is that a dehydration reaction occurs when using free polybasic acid or acid anhydride, and a corresponding dealcoholization reaction occurs when using ester derivative.

Particularly, 5-hydroxyisophthalic acid is preferable for use in terms of copolymerizability, availability and the like.

Note that, when using 5-hydroxyisophthalic acid, R1 in the general formula (1), which is a divalent linking group being a polybasic acid compound residue, is a part that excludes two carboxyl groups from the 5-hydroxyisophthalic acid.

[Polybasic acid compound containing C20-60 hydrocarbon group]

An suitable example of the polybasic acid compound having a C20-60 hydrocarbon group that is used in the present invention is a polybasic acid compound having a cyclic structure with a carbon number of 5 to 10 that is obtained by reaction of a monobasic unsaturated fatty acid having one or more double bonds or triple bonds with a carbon number of 10 to 24. One example of the reaction is the Diels-Alder reaction. For example, a polybasic acid compound containing a dimeric fatty acid (dimer acid) obtained by the Diels-Alder reaction by using, as a material, a natural fatty acid such as soybean oil fatty acid, tall oil fatty acid and canola oil fatty acid, and oleic acid, linolic acid, linolenic acid, erucic acid and the like made by purification of those natural fatty acids is suitably used.

One or two cyclic structures may be used, and when using two cyclic structures, two rings may be independent or continuous. The cyclic structure may be a saturated alicyclic structure, an unsaturated alicyclic structure or an aromatic ring, for example. Although the carboxyl group may directly bond to the cyclic structure, the carboxyl group preferably bonds to the cyclic structure through an aliphatic chain in terms of improving the solubility and the softness. The number of carbons between the carboxyl group and the cyclic structure is preferably 2 to 25.

Further, the polybasic acid compound having a C20-60 hydrocarbon group preferably has a chain alkyl group with a high degree of freedom and high hydrophobicity as a part other than the cyclic structure in terms of improving the solubility and the softness and reducing a dielectric constant and a dissipation factor. Two or more alkyl groups are preferable for one cyclic structure. The number of carbons of the alkyl group is preferably 2 to 25.

The polybasic acid compound having a C20-60 hydrocarbon group has, as the main ingredient, monomers containing a dimer generally derived from a dimer acid (dimeric fatty acid) as a residue, and is obtained as a composition of a material fatty acid or a trimer or more fatty acid. Particularly, the content of monomers containing a dimer derived from a dimer acid (dimeric fatty acid) as a residue is preferably 70 mass% or more and preferably 95 mass% or more in 100 mass% of monomers containing a C20-60 hydrocarbon group. Further, a dimmer where the degree of unsaturation is reduced by hydrogen addition (hydrogenation reaction) is preferably used in terms of oxidation resistance (particularly, coloring in a high-temperature region) and prevention of gelatification during synthesis. As the polybasic acid compound having a C20-60 hydrocarbon group, a monomer containing, as a residue, a dimmer derived from a monobasic unsaturated fatty acid with a carbon number of 10 to 24 (polybasic acid compound) is preferable for use.

Further, as a part of the polybasic acid compound having a C20-60 hydrocarbon group, a monomer containing, as a residue, a trimmer, which is tricarboxylic acid, derived from a monobasic unsaturated fatty acid with a carbon number of 10 to 24 is preferable for use.

Although the polybasic acid compound having a C20-60 hydrocarbon group can be obtained by a known reaction, a commercialized product may be used. Examples of commercialized products are "Pripol 1004", "Pripol 1006", "Pripol 1009", "Pripol 1013", "Pripol 1015", "Pripol 1017", "Pripol 1022", "Pripol 1025" and "Pripol 1040" manufactured by Croda Japan KK., "Empol 1008", Empol 1012, Empol 1016, Empol 1026, Empol 1028, Empol 1043, Empol 1061 and Empol 1062 manufactured by BASF Japan Co., Ltd. and the like. Those polybasic acid compounds can be used alone of in combination. Particularly, "Pripol 1009" with a carbon number of 36 can be suitably used because it is possible to obtain a polyamide excellent in heat resistance, moist heat resistance and dielectric properties while maintaining high adhesiveness. Further, "Pripol 1004", which has a structure with a carbon number of 44, can be suitably used because it is possible to obtain a polyamide excellent in dielectric properties and flexibility. Further, use of "Pripol 1040" that contains a tricarboxylic acid component, which is a trimer, by about 75 mass% allows an increase in the cohesive force of a polyamide, and it is can be suitably used in terms of improving the dimensional stability during hot press and the heat resistance.

Note that the cohesive force can be improved also by use of a monomer with a functionality of three or more which is exemplified as one of "other polybasic acid compounds", which is described later, as a trifunctional polybasic acid compound. However, while a monomer with a functionality of three or more which is described later has a relatively low molecular weight, the above described trimer, tricarboxylic acid component has a relatively high molecular weight. Accordingly the tricarboxylic acid component is more preferred for use in terms of reducing a dielectric constant and a dielectric constant, because it can efficiently reduce the amide bond concentration.

[Other polybasic acid compounds]

Polybasic acid compounds other than the polybasic acid compound having a phenolic hydroxyl group and the polybasic acid compound having a C20-60 hydrocarbon group are not particularly limited as long as they do not deviate from the spirit and scope of the present invention, and a dibasic acid compound or a polybasic acid compound with a functionality of three or more may be used.

Examples of the dibasic acid compound are:

aromatic dibasic acids such as phthalic acid, isophthalic acid, terephthalic acid, 1,4-naphthalenedicarboxylic acid, 2,6- naphthalenedicarboxylic acid, benzophenone-4, 4’-dicarboxylic acid and 4, 4’-biphenyldicarboxylic acid,
aliphatic dibasic acids such as oxalic acid, malonic acid, methylmalonic acid, succinic acid, glutaric acid, adipic acid, maleic acid, fumaric acid, malic acid, tartaric acid, thiomalic acid, pimelic acid, suberic acid, azelaic acid, sebacic acid, dodecanedioic acid, hexadecanedioic acid and diglycol acid,
alicyclic dibasic acids such as 1,3-cyclohexanedicarboxylic acid, 1,4-cyclohexanedicarboxylic acid and 1,3-cyclopentanedicarboxylic acid and the like.

Examples of the polybasic acid compound with a functionality of three or more are trimellitic acid, hydrogenated trimellitic acid, pyromellitic acid, hydrogenated pyromellitic acid, 1,4,5,8-naphthalenetetracarboxylic acid and the like.

Those polybasic acid compounds may be used alone or in combination for the polybasic acid compound having a phenolic hydroxyl group or the polybasic acid compound having a C20-60 hydrocarbon group. Particularly, isophthalic acid and 1,4- cyclohexanedicarboxylic acid can be suitably used because a tough polyamide with higher heat resistance can be obtained while maintaining high flexibility.

Further, by using a compound with a functionality of three or more, it is possible to introduce a branching structure to the polyamide. The obtained polyamide has high-molecular weight and increased cohesive force. As a result, it is possible to improve the dimensional stability and the heat resistance, particularly, without deteriorating the adhesiveness, flexibility and electrical insulating properties.

Further, a monofunctional compound may be also used in the present invention. By using the monofunctional compound, it is possible to reduce a carboxyl group and an amino group that can serve as a terminal functional group of a polyamide and thereby control the molecular weight of the obtained polyamide. As a result, it is possible to improve the temporal stability of polyamide resin, particularly.

Examples of a monobasic acid compound are a benzoic acid, 4-hydroxybenzoic acid, 2-ethylhexanoic acid and the like.

<Polyamine monomer ($m_2$)>

Although the polyamine compound having a phenolic hydroxyl group is not particularly limited, the polyamine represented by the following general formula (2) may be used as an example.

General formula (2)

HO — R$_3$ — OH, H$_2$N, NH$_2$

$R_3$ in the above formula indicates a direct bond or a group consisting of carbon, hydrogen, oxygen, nitrogen, sulfur or halogen, and examples are a divalent hydrocarbon group with a carbon number of 1 to 30 or a divalent hydrocarbon group with a carbon number of 1 to 30 where some or all of hydrogens are replaced by halogen atoms, -(C=O)-, -$SO_2$-, -O-, -S-,-NH-(C=O)-, -(C=O)-O-, a group represented by the following general formula (3), a group represented by the following general formula (4) and the like. In the formula, each of r and s indicates an integer of 1 to 20, and $R_4$ indicates a hydrogen atom or a methyl group.

General formula (3)

r

General formula (4)

OH
R4
s

The above-described $R_3$ is preferably a direct bond.

Note that, in the case of using the compound of the general formula (2), $R_2$ in the general formula (1), which is a divalent linking group being a polyamine compound residue, is a part where two amino groups are eliminated from

the compound of the general formula (2).

[Polyamine compound having C20-60 hydrocarbon group]

An example of the polyamine compound having a C20-60 hydrocarbon group is a compound where a carboxyl group of the above-described polybasic acid compound having a C20 to C60 hydrocarbon group is inverted to an amino group, and examples of a commercialized product are "Priamine 1071", "Priamine 1073", "Priamine 1074" and "Priamine 1075" manufactured by Croda Japan KK., "Versamine 551" manufactured by BASF Japan Co., Ltd. and the like. Those polyamine compounds may be used alone or in combination. Particularly, the use of "Priamine 1071" that contains a trimer, i.e. a triamine component by about 20 to 25 mass% allows an increase in the cohesive force of a polyamide. It can be preferably used for improving the dimensional stability during hot press and the heat resistance. Further, it is preferred to use triamine, which is a trimer, in terms of the effect of reducing a dielectric constant and a dissipation factor.
Note that, in terms of the production stability of a polyamide, the trimer triamine and the trimer tricarboxylic acid described above account for preferably 0.1 to 20 mass% and more preferably 1 to 10 mass% in total among 100 mass% of all monomers to be used to form the polyamide.

[Other polyamine compounds]

Polyamine compounds other than the polyamine compound having a phenolic hydroxyl group and the polyamine compound having a C20-60 hydrocarbon group are not particularly limited as long as they do not deviate from the spirit and scope of the present invention, and a diamine compound, a triamine compound or the like may be used.
Examples of the diamine compound are:

aromatic diamine such as 1,4-diaminobenzene, 1,3-diaminobenzene, 1,2-diaminobenzene, 1,5-diaminonaphthalene, 1,8- diaminonaphthalene, 2,3-diaminonaphthalene, 2,6-diaminotoluene, 2,4- diaminotoluene, 3,4-diaminotoluene, 4,4'-diaminodiphenylmethane, 3,4'-diaminodiphenyl ether, 4,4'-diaminodiphenyl ether, 4,4'-diamino-1,2-diphenylethane, 3,3'-diaminodiphenylmethane, 3,4'- diaminodiphenylmethane, 4,4'-diaminobenzophenone, 4,4'-diaminodiphenyl sulfone, 3,3'-diaminobenzophenone and 3,3'-diaminodiphenyl sulfone,
aliphatic polyamine such as ethylene diamine, 1,3-propanediamine, 1,4-butanediamine, 1,6-hexanediamine, 1,7-heptanediamine, 1,9-nonanediamine, 1,12-dodecamethylenediamine and m-xylene diamine, and
alicyclic diamine such as isophoronediamine, norbornanediamine, 1,2-cyclohexane diamine, 1,3-cyclohexane diamine, 1,4-cyclohexane diamine, 4,4'- diaminodicyclohexylmethane and piperazine and the like.

Examples of the polyamine compound with a functionality of three or more are 1,2,4-triaminobenzene, 3,4,4'-triaminodiphenyl ether and the like.
Note that, even when a compound has an aromatic ring, it is classified to an aliphatic compound when an amino group does not directly bond.
Those polyamine compounds may be used alone or in combination for the polyamine having a phenolic hydroxyl group and the polyamine having a C20-60 hydrocarbon group. Particularly, isophoronediamine and norbornanediamine can be suitably used because a tough polyamide with higher heat resistance can be obtained while maintaining high flexibility.
Further, by using a compound with a functionality of three or more, it is possible to introduce a branching structure to a polyamide, achieve a high-molecular weight and increase the cohesive force of the obtained polyamide. As a result, it is possible to improve the dimensional stability and the heat resistance, particularly, without negatively affecting the adhesiveness, the flexibility and the electrical insulating properties.
Further, a monofunctional compound may be also used in the present invention. By using the monofunctional compound, it is possible to reduce a carboxyl group and an amino group that can serve as a terminal functional group of a polyamide and thereby control the molecular weight of the obtained polyamide. As a result, it is possible to improve the temporal stability of polyamide resin, particularly. On the other hand, in the case where a carboxyl group and an amino group that can serve as a terminal functional group are not reduced by a monofunctional compound, a phenolic group, a carboxyl group and/or an amino group are mixed in resin, and when using the compound (B) with a functionality of three or more that can react with the phenolic hydroxyl group, the processability and the adhesiveness can be improved by utilization of a difference in reactivity among them, which is preferable. Examples of the monofunctional amine compound are aniline, 4-aminophenol, 2-ethylhexylamine and the like.
The phenolic hydroxyl group-containing polyamide (A-1) according to the present invention can be obtained by appropriately selecting the polybasic acid monomer ($m_1$) and the polyamine monomer ($m_2$) described above according to the properties that are desired to be particularly improved, such as the dimensional stability, the adhesiveness, the heat resistance, the flexibility and the electrical insulating properties.

Note that the polyamide (A-1) obtained by polymerization may be made by randomly polymerizing a component having a phenolic hydroxyl group and a component having a C20-60 hydrocarbon group, or may be a block polymer.
Specifically, a mixture of a plurality of types of polybasic acid monomer compounds and one type of polyamine compound may be polymerized, a mixture of a plurality of types of polybasic acid monomer compounds and a mixture of a plurality of types of polyamine compounds may be polymerized, one type of polybasic acid compound and a mixture of a plurality of types of polyamine compounds may be polymerized, or one type of polybasic acid compound and one type of polyamine compound may be polymerized and further it may be polymerized with another polybasic acid compound or another polyamine compound in accordance with a functional group remaining at the terminal.
The polyamide (A-1) according to the present invention contains preferably 10 to 95 mol%, more preferably 14 to 92 mol%, and still more preferably 18 to 88 mol%, of a compound having a C20-60 hydrocarbon group in the total 100 mol of all monomers used for formation, which are, the polybasic acid monomer ($m_1$) and the polyamine monomer ($m_2$), and a monobasic acid or a monofunctional amine compound that is used according to need.
A calculation method of the number of moles of monomers containing a C20-60 hydrocarbon group is described hereinafter. First, the molecular weight (M) of monomers containing a C20-60 hydrocarbon group is calculated by the following equation.

$$M=(56.11\times F\times 1000)/E$$

F: The number of functional groups of monomers containing a C20-60 hydrocarbon group
E: The acid value (mgKOH/g) of monomers containing a C20-60 hydrocarbon group
Next, the number of moles of the compounds containing a C20-60 hydrocarbon group used for polymerization is calculated by dividing the mass of the compounds containing a C20-60 hydrocarbon group used for polymerization by the above-described molecular weight (M).
The number of moles of each monomer used for polymerization is calculated in the same manner, and the calculated numbers are added together to obtain the number of moles of all monomers used for polymerization. Then, the number of moles of the compounds containing a C20-60 hydrocarbon group is divided by the number of moles of all monomers, and thereby obtaining the proportion (mol%) of the compounds containing a C20-60 hydrocarbon group.

<<Polyamide ester (A-2)>>

In the present invention, polyamide ester (A-2) having a side-chain phenolic hydroxyl group, a C20-60 hydrocarbon group and an ester bond, which is made by reaction of the polyamide (A-1) having a carboxylic acid at the terminal with a polyol compound, may be also used as one type of the phenolic hydroxyl group-containing polyamide (A).

[Polyol compound]

A polyol compound, which is a compound required when introducing an ester bond, is described hereinafter. The polyol compound that is used in the present invention may be any compound having two or more hydroxyl groups, and examples are:

aliphatic or alicyclic diols such as ethylene glycol, propylene glycol, 1,4-butanediol, 1,5-pentanediol, 1,6-hexanediol" 1,9-nonanediol, neopentyl glycol, 1,4-cyclohexanediol, 1,4-cyclohexanedimethanol, dimer diol, hydrogenated bisphenol A, and spiroglycol, and
aromatic diols such as 1,4-bis(2-hydroxyethoxy)benzene, 4,4'-methylenediphenol, 4,4'-dihydroxybiphenyl, o-,m-,and p-dihydroxybenzene, 1,2-indandiol, 1,3-naphthalenediol, 1,5- naphthalenediol, 1,7- naphthalenediol, 9,9'-bis(4-hydroxyphenyl)fluorene, and 9,9'-bis(3-methyl-4-hydroxyphenyl)fluorene.

Other examples are phosphorus atom-containing diol, sulfur atom-containing diol, bromine atom-containing diol and the like.
Further, a compound having a structure including repetitive units with a degree of polymerization of two or more may be used, and examples are polyester polyols, polycarbonate polyols, polyether polyols, polybutadiene polyols, polysiloxane polyols, and the like.
By making such a polyol compound react with the polyamide (A-1) and thereby introducing an ester bond, it is possible to improve the solubility to a commonly used solvent compared with the case of not having an ester bond. The ratio of amide bonds and ester bonds in the polyamide ester (A-2) is preferably amide bonds/ester bonds=0.5 or more, and more preferably 0.7 or more, and still more preferably 1 or more.

By setting the amide bond/ester bond ratio to 0.5 or more, it is possible to take advantage of high heat resistance, moldability and processability and insulation reliability and also improve the solubility to a commonly used solvent. In the case where greater importance is placed on the heat resistance, the moldability and processability and the insulation reliability than on the solubility to a commonly used solvent, it is preferred to increase the proportion of amide bonds.

The theoretical amide bond/ester bond ratio in the polyamide (A-2) can be calculated as follows.

The smaller number of mols of a functional group (i.e., amino group) between the number of mols of a carboxyl group in the polybasic acid compound and the number of mols of an amino group in the polyamine compound used for polyamide polymerization is set to the number of mols of amide bonds. On the other hand, the smaller number of mols of a functional group between the number of mols of a carboxyl group in the polyamide and the number of mols of an alcoholic hydroxyl group in the polyol compound used for polyester polymerization is set to the number of mols of ester bonds. Then, the number of mols of amide bonds is divided by the number of mols of ester bonds, thereby calculating the amide bond/ester bond mol ratio.

Note that the number of mols of each of the functional groups, which are the carboxyl group, the amino group and the alcoholic hydroxyl group, is obtained by multiplying the number of mols of each monomer where each functional group is contained by the number of functional groups contained in the monomer. Further, the number of mols of each monomer can be calculcated from the mass of the monomer used for polymerization and the molecular weight of the monomer.

<<Polyamide (A-3)>>

The polyamide (A-3) is a polyamide made by mixing polyamides (a-1) and (a-2). The polyamide (a-1) is made by the polymerization of a polybasic acid monomer ($m_3$) and a polyamine monomer ($m_4$), has a phenolic hydroxyl group on the side chain, and does not have a C20-60 hydrocarbon group. Another polybasic acid monomer and another polyamine monomer may be appropriately used as long as the above conditions are satisfied.

Specifically, the polybasic acid monomer ($m_3$) may be at least one selected from a group consisting of a polybasic acid compound having a phenolic hydroxyl group and other polybasic acid compounds (excluding a polybasic acid compound having a C20-60 hydrocarbon group), and the polyamine monomer ($m_4$) may be at least one selected from a group consisting of a polyamine compound having a phenolic hydroxyl group and other polyamine compounds (excluding a polyamine compound having a C20-60 hydrocarbon group), so that the phenolic hydroxyl group is contained in the polymer.

At least one of the polybasic acid monomer ($m_3$) and the polyamine monomer ($m_4$) has a phenolic hydroxyl group. Monomers with a valency of two and monomers with a valency of three or more may be combined to introduce a branching structure and adjust an appropriate molecular weight. Further, monomers with a valency of 1 may be used to maintain an appropriate molecular weight.

In other words, the polyamide (a-1) is a polyamide that has a phenolic hydroxyl group on the side chain but does not have a C20-60 hydrocarbon group.

On the other hand, the polybasic acid monomer ($m_5$) is at least one selected from a group consisting of a polybasic acid compound having a C20-60 hydrocarbon group and other polybasic acid compounds (excluding a polybasic acid compound having a phenolic hydroxyl group), and the polyamine monomer ($m_6$) may be at least one selected from a group consisting of a polyamine compound having a C20-60 hydrocarbon group and other polyamine compounds (excluding a polyamine compound having a phenolic hydroxyl group).

At least one of the polybasic acid monomer ($m_5$) and the polyamine monomer ($m_6$) has a C20-60 hydrocarbon group.

In other words, the polyamide (a-2) is polyamide that has a C20-60 hydrocarbon group but does not have a phenolic hydroxyl group on the side chain.

Thus, the polyamide (A-3) is a mixture of the polyamide (a-1) that has a phenolic hydroxyl group on the side chain but does not have a C20-60 hydrocarbon group and the polyamide (a-2) that has a C20-60 hydrocarbon group but does not have a phenolic hydroxyl group on the side chain.

The compound (B) with a functionality of three or more that can react with a phenolic hydroxyl group, which is described later, can often react with at least one of a carboxyl group and an amino group, in addition that it can react with a phenolic hydroxyl group.

When heat curing the thermosetting resin composition containing the mixture (A-3) and the compound (B) with a functionality of three or more that can react with a phenolic hydroxyl group, if a compound that can react also with at least one of a carboxyl group and an amino group is used as the compound (B) with a functionality of three or more that can react with a phenolic hydroxyl group, it is possible to make use of the terminal carboxyl group and the terminal amino group of the phenolic hydroxyl group-containing polyamide (a-1) and the C20-60 hydrocarbon group-containing polyamide (a-2) in the mixture (A-3) for heat curing reaction.

Although the mixture ratio of the phenolic hydroxyl group-containing polyamide (a-1) and the C20-60 hydrocarbon group-containing polyamide (a-2) can be appropriately adjusted depending on the phenolic hydroxyl value or the molecular weight of (a-1), it is preferred that phenolic hydroxyl group-containing polyamide : C20-60 hydrocarbon group-containing polyamide = 5:95 to 80:20 and, more preferably, 10:90 to 50:50 (mass ratio).

Note that the meaning of "mixture" or "mixing" as referred to regarding the polyamide (A-3) includes the following cases. Specifically, it includes the case where, after a mixture of the polyamide (a-1) and the polyamide (a-2) is obtained, the compound (B) with a functionality of three or more that can react with a phenolic hydroxyl group, which is described later, is combined with the mixture, the case where the polyamide (a-1), the polyamide (a-2), and the compound (B) with a functionality of three or more that can react with a phenolic hydroxyl group, which is described later, are combined together, the case where, after the polyamide (a-1) and the compound (B) with a functionality of three or more that can react with a phenolic hydroxyl group, which is described later, are combined together, the polyamide (a-2) is further combined, and the other way around.

The polybasic acid monomer ($m_3$) may be the polybasic acid monomer ($m_4$) other than the polybasic acid compound containing a C20-60 hydrocarbon group. Further, a monobasic acid compound can be also used.

The polyamine monomer ($m_4$) may be the polyamine monomer ($m_2$) other than the polyamine compound containing a C20-60 hydrocarbon group. Further, a monofunctional amine compound can be also used.

The polybasic acid monomer ($m_5$) may be the polybasic acid monomer ($m_1$) other than the polybasic acid compound containing a phenolic hydroxyl group. Further, a monobasic acid compound can be also used.

The polyamine monomer ($m_6$) may be the polyamine monomer ($m_2$) other than the polyamine compound containing a phenolic hydroxyl group. Further, a monofunctional amine compound can be also used.

The polyamide (A-3) according to the present invention preferably contains 10 to 95 mol%, more preferably by 14 to 92 mol%, and still preferably by 18 to 88 mol% of the compound having a C20-60 hydrocarbon group in the total 100 mol of all monomers used for formation, which are, the polybasic acid monomer ($m_3$), the polyamine monomer ($m_4$), the polybasic acid monomer ($m_5$), the polyamine monomer ($m_6$), and a monobasic acid or a monofunctional amine compound that is used according to need.

<Specifications of phenolic hydroxyl group-containing polyamide (A)>

The specifications (phenolic hydroxyl value, mass-average molecular weight, glass-transition temperature) of the phenolic hydroxyl group-containing polyamide (A) according to the present invention are described hereinafter.

The phenolic hydroxyl group-containing polyamide (A) according to the present invention may have a carboxyl group or an amino group at the terminal or may not have any functional group at the terminal, as long as it contains a phenolic hydroxyl group on the side chain of the polyamide. The amount of phenolic hydroxyl groups contained on the side chain of the polyamide may be appropriately adjusted according to the type and the amount of the compound (B) with a functionality of three or more that can react with the phenolic hydroxyl group.

[Phenolic hydroxyl value]

To be specific, the phenolic hydroxyl value of the phenolic hydroxyl group-containing polyamide (A) according to the present invention is preferably 1 to 80 mgKOH/g, more preferably 5 to 60 mgKOH/g, and still more preferably 5 to 30 mgKOH/g. By using the polyamide with the phenolic hydroxyl value of 1 mgKOH/g or more, it is possible to form a cross-linked structure and thereby improve the resistance of a coating after heat curing. Further, by using the polyamide with the phenolic hydroxyl value of 80 mgKOH/g or less, it is possible to obtain a cured coating having high hardness, adhesiveness and flexibility. When the polyamide where the phenolic hydroxyl value is close to 1 mgKOH/g in the range of 1 to 80 mgKOH/g is used, the adhesiveness and flexibility of the obtained coating are improved. On the other hand, when the polyamide where the phenolic hydroxyl value is close to 80 mgKOH/g is used, the heat resistance of the finally obtained coating are improved because there are many cross-linking points. In this manner, the phenolic hydroxyl value of the phenolic hydroxyl group-containing polyamide (A) according to the present invention can be adjusted according to purpose within the range of 1 to 80 mgKOH/g.

The above-described phenolic hydroxyl value can be adjusted by the charge ratio (polymerization composition) of monomers having a phenolic hydroxyl group in the monomers in the case (i). On the other hand, in the case (ii), it can be adjusted by the ratio of monomers having a phenolic hydroxyl group in all monomers of the polyamide (a-1), (a-2). For example, if reaction is made using only 5-hydroxyisophthalic acid having a phenolic hydroxyl group as the polybasic acid compound and using only dimerdiamine not having a phenolic hydroxyl group as the polyamine compound, the phenolic hydroxyl value of the phenolic hydroxyl group-containing polyamide (A) that is finally obtained can be close to 80 mgKOH/g, thereby further improving the heat resistance of the cured coating.

Note that, in the case of the mixture (A-3), out of the phenolic hydroxyl group-containing polyamide (A), the phenolic hydroxyl value of the mixture is the phenolic hydroxyl value of the phenolic hydroxyl group-containing polyamide (A).

[Mass-average molecular weight]

The mass-average molecular weight of the polyamide (A-1), out of the phenolic hydroxyl group-containing polyamide (A), is preferably 3,000 to 1,000,000, more preferably 5,000 to 550,000, and still more preferably 10,000 to 300,000 in terms of the easiness of handling and the adhesiveness and the heat resistance of the thermosetting resin composition made of the same.

The mass-average molecular weight of the polyamide (a-1), out of the phenolic hydroxyl group-containing polyamide (A), is preferably 500 to 30,000, more preferably 1,000 to 20,000, and still more preferably 1,000 to 10,000 in terms of the solubility to a commonly used solvent, which is described later.

Further, the mass-average molecular weight of the polyamide (a-2), out of the phenolic hydroxyl group-containing polyamide (A), is preferably in the same range as that of the polyamide (A-1).

[Glass-transition temperature of phenolic hydroxyl group-containing polyamide (A)]

The glass-transition temperature of the phenolic hydroxyl group-containing polyamide (A) according to the present invention is preferably -40°C to 120°C and more preferably -30°C to 80°C. By adjusting the glass-transition temperature of the phenolic hydroxyl group-containing polyamide (A) in the range of -40°C to 120°C, it is possible to suppress the excess during hot press, achieve suitable embedding in a substrate, and enhance the adhesiveness.

The adjustment of the glass-transition temperature can be made by appropriately setting the ratio of the polybasic acid compound having a C20-60 hydrocarbon group or the polyamine compound having a C20-60 hydrocarbon group. For example, by increasing the compounding ratio of the polybasic acid compound having a C20-60 hydrocarbon group or the polyamine compound having a C20-60 hydrocarbon group, the glass-transition temperature can be adjusted in the range close to -40°C because it is possible to reduce the concentration of an amide bond with high moisture absorption and impart the flexible flexibility originated from a dimerization fatty acid.

Note that, in the case of the mixture (A-3), out of the phenolic hydroxyl group-containing polyamide (A), the glass-transition temperature of the mixture is the glass-transition temperature of the phenolic hydroxyl group-containing polyamide (A).

[Organic solvent solubility of phenolic hydroxyl group-containing polyamide (A)]

The phenolic hydroxyl group-containing polyamide (A) according to the present invention is widely soluble in a commonly used organic solvent. Being soluble means that 5 parts by mass or more of the polyamide (A) dissolves at 25°C in 95 parts by mass of a mixed solvent of a commonly used solvent such as a hydrocarbons solvent, an alcohols solvent, a ketones solvent and an esters solvent. Particularly, it is preferred that 5 parts by mass or more of the polyamide (A) dissolves at 25°C in 95 parts by mass of a mixed solvent of toluene/isopropanol=50/50 (mass ratio).

Examples of the hydrocarbons solvent are benzene, toluene, ethyl benzene, xylene, cyclohexane, hexane and the like. Examples of the alcohols solvent are methanol, ethanol, propanol, isopropanol, butanol, isobutanol, sec- butanol, tert-butanol and the like. Examples of the ketones solvent are acetone, methyl ethyl ketone, methyl isobutyl ketone, cyclohexanone and the like. Examples of the esters solvent are methyl acetate, ethyl acetate, propyl acetate, butyl acetate and the like.

<Synthesis of phenolic hydroxyl group-containing polyamide (A)>

A synthesis method of the phenolic hydroxyl group-containing polyamide (A) according to the present invention is described hereinafter.

Polymerization conditions of the phenolic hydroxyl group-containing polyamide (A) according to the present invention are not particularly limited, and known conditions such as melt polymerization, interfacial polymerization, solution polymerization, bulk polymerization, solid-phase polymerization and a combination of those may be used. In general, industrially, reaction is made at 150°C to 300°C for 1 to 24 hours in the presence or absence of a catalyzer. Preferably, reaction is made at 180°C to 270°C under reduced pressure of atmospheric pressure or less in order to promote the dehydration and or dealcoholization reaction and prevent coloring and decomposition reaction due to a high temperature.

When synthesizing the phenolic hydroxyl group-containing polyamide (A-1), specified quantities of the polybasic acid compound having a phenolic hydroxyl group or/and the polyamine compound having a phenolic hydroxyl group, the polybasic acid compound having a C20-60 hydrocarbon group or/and the polyamine compound having a C20-60 hydrocarbon group, and ion-exchanged water are charged in a flask filled with nitrogen gas, and uniformly dissolve or dispersed by heating and stirring at 20°C to 100°C, for example. After that, the temperature is gradually raised to 230°C, eliminating the ion-exchanged water and water generated by the reaction, and when it reaches 230°C, the pressure is

reduced to about 15 mmHg, kept for about 1 hour, and thereby the phenolic hydroxyl group-containing polyamide (A-1) is obtained.

Note that, salt is formed and is likely to be hardened when the polybasic acid compound and the polyamine compound are mixed together. If those compounds are mixed together in the presence of ion-exchanged water, the formed salt dissolves or is dispersed in the ion-exchanged water, and therefore it is preferred to use the ion-exchanged water in terms of the safety or the like.

When synthesizing the phenolic hydroxyl group-containing polyamide ester (A-2) having an ester bond, the phenolic hydroxyl group-containing polyamide (A-1) with a terminal carboxylic acid obtained by reaction with the total molar ratio of the polybasic acid compound being greater than the total molar ratio of the polyamine compound is synthesized, for example. After that, a polyol compound and an esterification catalyst are added, the temperature is gradually raised again to 230°C, then the pressure is reduced to 1 to 2 mmHg and kept for 3 hours, and thereby the phenolic hydroxyl group-containing polyamide (A-2) is obtained.

Specific examples of the catalyst that can be used to obtain the phenolic hydroxyl group-containing polyamide (A-1) and the phenolic hydroxyl group-containing polyamide ester (A-2) having an ester bond are inorganic phosphorous compounds such as phosphoric acid, phosphorous acid, hypophosphorous acid, pyrophosphoric acid, polyphosphoric acid, their alkali metal salt and alkaline-earth metal salt, phosphorous acid ester such as triphenyl phosphite and diphenyl phosphonite, titanium catalysts such as tetrabutylorthotitanate and tetraisopropylorthotitanate, tin catalysts such as dibutyltin oxide, dibutyltin laurate and monobutylhydroxytin oxide, zirconium catalysts such as tetrabutoxyzirconium, zirconium acetate, and zirconium octylate and the like.

Two type or more of those catalysts may be used in combination. Further, those catalysts may be contained in the phenolic hydroxyl group-containing polyamide (A), which des not cause any problem when implementing the present invention.

Further, by-products are inorganic salts catalysts such as decomposition products of the catalyst used, oxidation products of the decomposition products or their degeneration products, by-products of amide compounds such as oligomer, and they may be contained in the phenolic hydroxyl group-containing polyamide (A).

<Compound (B) with a functionality of three or more that can react with phenolic hydroxyl group>

The thermosetting resin composition according to the present invention contains the above-described phenolic hydroxyl group-containing polyamide (A) and the compound (B) with a functionality of three or more that can react with a phenolic hydroxyl group. The compound (B) with a functionality of three or more that can react with a phenolic hydroxyl group is described hereinafter. The thermosetting resin composition according to the present invention uses the compound (B) as a curing agent of the above-described phenolic hydroxyl group-containing polyamide (A). Note that, in addition to the compound (B) with a functionality of three or more, a bifunctional compound (C) that can react with a phenolic hydroxyl group (which is also referred to hereinafter as "compound (C)") can be added in the scope of the spirit of the present invention. In the case of adding the compound (C), it is preferably 100 parts by mass or less and more preferably 60 parts by mass with respect to 100 parts by mass of the compound (B) in terms of effectively increasing the cross-linked structure.

[Epoxy group-containing compound]

An epoxy group-containing compound with a functionality of three or more that can be used as the compound (B) in the present invention is not particularly limited as long as it is a compound having an epoxy group in the molecule, and epoxy resin such as glycidyl ether epoxy resin, glycidyl amine epoxy resin, glycidyl ester epoxy resin and cyclic aliphatic (alicyclic) epoxy resin may be used.

Examples of the glycidyl ether epoxy resin are cresol novolac epoxy resin, phenol novolac epoxy resin, tetrakis(glycidyloxyphenyl)ethane and the like.

Examples of the glycidyl amine epoxy resin are tetraglycidyl diamino diphenylmetane, tetraglycidyl meta-xylene diamine and the like.

As the epoxy group-containing compound, it is preferred to use tetrakis(glycidyloxyphenyl)ethane or tetraglycidyl diamino diphenylmetane in terms of high adhesiveness and heat resistance.

As the epoxy group-containing compound that can be used as the compound (C), examples of the glycidyl ether epoxy resin are bisphenol A epoxy resin, bisphenol F epoxy resin, dicyclopentadiene epoxy resin and the like.

Examples of the glycidyl ester epoxy resin are diglycidyl phthalate, diglycidyl hexahydrophthalate, diglycidyl tetrahydrophthalate and the like.

Examples of the cyclic aliphatic (alicyclic) epoxy resin are 3,4-epoxycyclohexylmethyl 3',4'-epoxycyclohexanecarboxylate and the like.

As the epoxy group-containing compound, one type or two or more types of the compound (B) may be used,

or the compound (B) may be used in combination with the compound (C).

[Isocyanate compound]

An isocyanate group-containing compound that can be used as the compound (B) is not particularly limited as long as it is a compound having three or more isocyanate groups in the molecule. Although any of the isocyanate group that is blocked with a blocking agent and the isocyanate group that is not blocked may be used, the one blocked with a blocking agent is preferred for use.

The isocyanate group-containing compound that can be used as the bifunctional compound (C) that can react with a phenolic hydroxyl group is not particularly limited, and examples are aromatic diisocyanate such as 4,4'-diphenylmethane diisocyanate, 2,4-torulene diisocyanate and 2,6-torulene diisocyanate, aliphatic diisocyanate such as hexamethylene diisocyanate, and alicyclic diisocyanate such as isophorone diisocyanate.

The isocyanate group-containing compound that can be used as the compound (B) with a functionality of three or more that can react with a phenolic hydroxyl group is not particularly limited, and examples are trimethylolpropane adduct of diisocyanate described above, biuret obtained by reaction with water, and trimer having an isocyanurate ring.

The blocked isocyanate compound is not particularly limited as long as the isocyanate group in the isocyanate group-containing compound is a blocked isocyanate group-containing compound that is protected by ε-caprolactam, MEK-oxime or the like. To be specific, the isocyanate group in the isocyanate group-containing compound that is blocked by ε-caprolactam, MEK- oxime, cyclohexanone oxime, pyrazole, phenol or the like is used. Particularly, hexamethylene diisocyanate trimer having an isocyanurate ring and blocked with MEK-oxime or pyrazole is highly preferable because it exhibits high adhesion strength to a jointing material such as polyamide and copper and high soldering heat resistance, in addition to good preservation stability, when used in the present invention.

[Carbodiimide group-containing compound]

A carbodiimide group-containing compound that can be used as the compound (B) with a functionality of three or more that can react with a phenolic hydroxyl group may be Carbodilite series manufactured by Nisshinbo Chemical Inc.. Particularly, Carbodilite V-01, 03, 05, 07 and 09 are preferred for use because it has high compatibility with an organic solvent.

[Metal chelate compound]

A metal chelate compound that can be used as the compound (B) with a functionality of three or more that can react with a phenolic hydroxyl group may be an aluminum chelate compound, a titanium chelate compound, a zirconium chelate compound and the like; however, it is not particularly limited because a chelate bond can be formed when a central metal is a variety of metals such as iron, cobalt and indium. Note that the number of functional groups of metal chelate, which is described herein, and metal alkoxide and metal acylate, which are described later, are calculated as the valency of the central metal, and those having three or more functions, which are those with a central metal valency of three or more, can be used as the compound (B).

Typical examples of the aluminum chelate compound that is used in the present invention are aluminum acetylacetonate, aluminum ethylacetoacetate and the like.

Typical examples of the titanium chelate compound are titanium acetylacetonate, titanium ethylacetoacetate, titanium octyleneglycolate, titanium lactate, titanium triethanolaminate, polytitanium acetyl acetylacetonato and the like.

Typical examples of the zirconium chelate compound are zirconium acetylacetonate, zirconium ethylacetylacetonate, zirconium lactate ammonium salt and the like.

[Metal alkoxide]

A metal alkoxide compound may be an aluminum alkoxide compound, a titanium alkoxide compound, a zirconium alkoxide compound and the like; however, it is not particularly limited because an alkoxide bond can be formed when a central metal is a variety of metals such as iron, cobalt and indium.

Typical examples of the aluminum alkoxide compound are aluminum isopropoxide, aluminum butyrate, aluminum ethylate and the like.

Typical examples of the titanium alkoxide compound are isopropyl titanate, n-butyltitanate, butyltitanate dimmer, tetraoctyl titanate, tertiary-amyltitanate, tertiary-butyltitanate, tetrastearyl titanate and the like.

Typical examples of the zirconium alkoxide compound are n-propylzirconate, n-butylzirconate and the like.

[Metal acylate]

A metal acylate compound may be an aluminum acylate compound, a titanium acylate compound, a zirconium acylate compound and the like; however, it is not particularly limited because an alkoxide bond can be formed when a central metal is a variety of metals such as iron, cobalt and indium.

The compound (B) with a functionality of three or more includes a compound that contains the same type of functional group with a functionality of three or more in one molecule and a compound that contains different types of functional groups with a functionality of three or more in total. For example, a compound where chelate, alkoxide and acylate are mixed in one molecule can be also suitable for use.

In the present invention, one type of the compound (B) may be used, or a plurality of types of the compound (B) may be used in combination. It is preferred to use a plurality of types in combination because the synergistic effect such as an increase in processability and adhesiveness resulting from a difference in reactivity is obtained when using the polyamide (A) where a phenolic group, a carboxyl group and/or an amino group are mixed. Particularly, use of "at least one selected from a group consisting of metal chelate, metal alkoxide and metal acylate" and "epoxy group-containing compound with a functionality of three or more" is preferable because they are largely different in reactivity and also different in the characteristics of physical properties that can be improved, and therefore the significant synergistic effect can be obtained. The quantity of the compound (B) to be used may be determined in consideration of the usage and the like of the thermosetting resin composition according to the present invention, and it is not particularly limited. It is, however, preferred to add 0.5 to 100 parts by mass, more preferably 1 to 80 parts by mass, of the compound (B) to 100 parts by mass of the phenolic hydroxyl group-containing polyamide (A). By using the compound (B), the crosslink density of the thermosetting resin composition according to the present invention can be adjusted to an appropriate value, and it is possible to further improve the various physical properties of a coating after curing. When the quantity of the compound (B) used is close to 0.5 parts by mass, it is possible to prevent the crosslink density of a coating after heat curing from being too high, and it is thereby possible to obtain desired flexibility and adhesiveness. Further, by suppressing an increase in polar functional group, it is possible to obtain a desired dielectric constant, dissipation factor and moist heat resistance. On the other hand, when the quantity of the compound (B) used is close to 100 parts by mass, it is possible to further increase the crosslink density of a coating after heat curing, and it is thereby possible to improve the coating resistance such as the electrical insulating properties of a coating.

In the present invention, a compound that can react with a carboxyl group and a compound that can react with an amino group can be used in combination with the compound (B), although it is uncertain whether they react with a phenolic hydroxyl group.

Examples of the compound that can react with a carboxyl group are an aziridine compound, $\beta$-hydroxyalkylamide group-containing compound, dicyandiamide and the like. Examples of the compound that can react with an amino group are a maleimide compound and the like.

Particularly, 2,2-bis(hydroxymethyl)butanol tris[3-(1-aziridinyl)propionate] is suitably used in the present invention because it is possible to suppress the occurrence of the excess during heat curing and further to improve the heat resistance while maintaining the softness of a cured coating when used in the present invention.

In the present invention, a compound that directly contributes to curing reaction can be added as an accelerator. Examples of the accelerator are a phosphine compound, a phosphonium salt, an imidazole compound, a tertiary amine compound and the like.

The thermosetting resin composition according to the present invention contains the phenolic hydroxyl group-containing polyamide (A) and the compound (B) as essential ingredients, and may contain an organic solvent as appropriate.

For example, in the case of obtaining a sheet-like adhesive (which is refereed to also as an adhesive sheet, an adhesive film and the like) by using the thermosetting resin composition according to the present invention, it is preferred to use a low-boiling solvent because it is necessary to dry the solvent from the thermosetting resin composition in the solution state. On the other hand, if the boiling point of a solvent is too low, the stability during coating is deteriorated.

In the case of obtaining a liquid resist ink by using the thermosetting resin composition according to the present invention, it is preferred to use a high-boiling solvent in order to minimize the volatilization of the solvent until a coating on a substrate is completed, such as during a preservation process and a coating process.

Examples of the low-boiling solvent are toluene, cyclohexane, hexane, isopropanol, methyl ethyl ketone, ethyl acetate and the like.

Examples of the high-boiling solvent are carbitol acetate, methoxypropylacetate, cyclohexanone, diisobutyl ketone, N,N-dimethylformamide, N,N-dimethylacetamide, N-methyl-2-pyrrolidone, dimethyl sulfoxide and the like.

In the present invention, one type of those organic solvents may be used alone, or a plurality of types of those organic solvents may be used in combination.

In the case of using a solvent when generating the phenolic hydroxyl group-containing polyamide (A), a thermosetting resin composition that contains the solvent may be obtained, or a liquid thermosetting resin composition may

be obtained by adding another solvent after distilling away the solvent used when generating the phenolic hydroxyl group-containing polyamide (A).

The solid content of the thermosetting resin composition according to the present invention is 5 to 80 mass%, and preferably 10 to 50 mass% in terms of the easiness of handling.

<Other additives>

In addition to those described above, dye, pigment, fire retardant, anti-oxidant, polymerization inhibitor, antifoaming agent, leveling agent, ionic collector, humectant, viscosity modifier, antiseptic agent, anti-fungus agent, antistatic agent, antiblocking agent, ultraviolet absorbing agent, infrared absorbing agent, electromagnetic shielding material, filler and the like may be added as optional ingredients to the thermosetting resin composition according to the present invention within the range of not deviating from its purpose.

Particularly, it is preferred to add a fire retardant when the thermosetting resin composition is used for an insulating member to be placed in direct contact with a circuit (e.g., circuit protection film, coverlay layer, interlayer insulating material etc.) or a member near a circuit which can be heated to a high temperature (e.g., printed-wiring board adhesive, supporting substrate etc.) in electronic material applications. Further, an electrically-conductive adhesive or an electromagnetic shielding sheet may be obtained by combining conducting particles.

<Sheet-like thermosetting resin composition>

The thermosetting resin composition in the solution state is applied to at least one side of a releasable substrate and dried generally at 40° to 150°C, and thereby a sheet-like thermosetting resin composition in the B stage state can be produced. The other side of the sheet-like thermosetting resin composition can be covered with the releasable substrate. The sheet-like thermosetting resin composition can be used as an adhesive sheet as described later. The dried film thickness of the sheet-like thermosetting resin composition is preferably 5 to 500 μm and more preferably 10 to 100 μm in terms of obtaining sufficient adhesiveness and soldering heat resistance, and the easiness of handling.

A method of application may be comma coating, knife coating, die coating, rip coating, roll coating, curtain coating, bar coating, gravure printing, flexographic printing, dip coating, spray coating, spin coating and the like, for example.

<Cured material>

The thermosetting resin composition according to the present invention in the form of a liquid is applied to a substrate, heated, dried and cured, and thereby a cured material can be formed on the substrate.

Alternatively, the thermosetting resin composition in the form of a liquid nay be applied to a substrate and heated and dried, and then further heated with another substrate (which is also referred to as adhered or adhesion target) superimposed thereon, and thereby the thermosetting resin composition is cured, and the both substrates can be adhered together.

Alternatively, the thermosetting resin composition in the form of a sheet (adhesive sheet) may be obtained from the thermosetting resin composition in the form of a liquid as described above, the sheet may be interposed between two or more substrates and heated, and thereby the thermosetting resin composition is cured, and the two or more substrates can be adhered together.

The thermosetting resin composition according to the present invention can be cured by heating at 60° to 230°C for 5 minutes to 2 hours.

The glass-transition temperature of the cured material that is obtained by heat curing the thermosetting resin composition according to the present invention is preferably -40° to 150°C and more preferably -20° to 150°C. By adjusting the glass-transition temperature of the above-described phenolic hydroxyl group-containing polyamide (A) in the range of -40° to 120°C, it is possible to bring out the flexibility and the electrical insulating properties after curing in good balance.

<Printed-wiring board>

Next, the thermosetting resin composition can be suitably used as a protective layer of a printed-wiring board. For example, the thermosetting resin composition in the form of a sheet is superimposed on a plastic film having softness and insulating properties such as polyester and polyimide so as to cover a conductor pattern of a flexible printed-wiring board where the conductor pattern is formed by print technology, and it is heated and pressurized to cure the thermosetting resin composition, and thereby a flexible printed-wiring board with the protective layer can be obtained. Instead of the thermosetting resin composition in the form of a sheet, the thermosetting resin composition in the form of a liquid may be applied, dried and cured to form the protective layer.

Further, the thermosetting resin composition in the form of a sheet (adhesive sheet) is interposed between a plurality of flexible printed-wiring boards after removing a releasable substrate placed over the surface, and it is heated and pressurized to cure the thermosetting resin composition, and thereby a multilayer flexible printed-wiring board can be obtained. A copper foil and a heat resistance and insulating flexible substrate may be laminated by using the thermosetting resin composition according to the present invention.

Instead of the thermosetting resin composition in the form of a sheet, the thermosetting resin composition in the form of a liquid may be applied to one flexible printed-wiring board and dried, and another flexible printed-wiring board or a heat resistance and insulating flexible substrate may be superimposed on the dried material and then heated and pressurized, and thereby a laminated product of the same sort can be obtained.

Further, a flexible printed-wiring board with a reinforcing board can be obtained by using the thermosetting resin composition according to the present invention. The flexible printed-wiring board with a reinforcing board is the one where a reinforcing board such as glass epoxy, metal or polyimide is attached to a part of a flexible printed-wiring board. The thermosetting resin composition in the form of a sheet (adhesive sheet) is interposed between a flexible printed-wiring board and a reinforcing board after removing a releasable substrate placed over the surface, and it is heated and pressurized to cure the thermosetting resin composition, and thereby the reinforcing board can be attached to the flexible printed-wiring board.

The thermosetting resin composition in the form of a liquid may be used Instead of the thermosetting resin composition in the form of a sheet as described above.

Note that, as a method of obtaining a flexible printed-wiring board having a conductive circuit, a photosensitive etching resist layer is formed on a copper foil of a flexible copper-clad board formed by placing a copper foil on a base film with or without an adhesive layer interposed therebetween, it is exposed to light through a mask film having a circuit pattern to cure only the exposed part, and then an unexposed part of the copper foil is removed by etching, and the remaining resist layer is removed or the like, and thereby a conductive circuit can be formed from the copper foil. Alternatively, necessary circuits may be placed on a base film by sputtering, plating or the like.

## Examples

Although the present invention is described more specifically hereinafter using examples, the following examples do not limit the scope of the claims of the present invention. Note that "parts" and "%" in the examples indicate "parts by mass" and "mass% ", respectively, and Mw indicates a mass-average molecular weight, and Tg indicates a glass-transition temperature.

<Measurement method of phenolic hydroxyl value>

The phenolic hydroxyl value represents the amount of phenolic hydroxyl group contained in 1g of phenolic hydroxyl group-containing polyamide by the amount of potassium hydroxide (mg) that is required to neutralize an acetic acid bonding to the phenolic hydroxyl group when the phenolic hydroxyl group is acetylated. The phenolic hydroxyl value was measured according to JIS K0070. In the present invention, when calculating the phenolic hydroxyl value of a phenolic hydroxyl group-containing polyamide of a terminal carboxylic acid, an acid value is taken into account as represented by the following formula.

<Measurement of phenolic hydroxyl value>

Approximately 1g of sample was precisely measured into a stoppered Erlenmeyer flask, 100mL of cyclohexanone solution was added to dissolve the sample. Further, precisely 5mL of acetylating agent (100mL of solution made by dissolving 25g of acetic anhydride in pyridine) was added and stirred for about one hour. Furthermore, a phenolphthalein reagent was added as an indicator and sustained for 30 seconds. After that, titration was performed with 0.5N alcoholic potassium hydroxide solution until the solution became rose pink.

The hydroxyl value was calculated by the following formula (in units of mgKOH/g)

$$\text{Hydroxyl value (mgKOH/g)} = [\{(b-a)\times F\times 28.05\}/S]+D$$

where S: Amount of sample collected (g)
a: Amount of 0.5N alcoholic potassium hydroxide solution consumed (mL)
b: Amount of 0.5N alcoholic potassium hydroxide solution consumed (mL) in blank test
F: Titer of 0.5N alcoholic potassium hydroxide solution

D: Acid value (mgKOH/g)

<Measurement method of acid value>

Approximately 1g of sample was precisely measured into a stoppered Erlenmeyer flask, 100mL of cyclohexanone solution was added to dissolve the sample. Further, a phenolphthalein reagent was added as an indicator and sustained for 30 seconds. After that, titration was performed with 0.1N alcoholic potassium hydroxide solution until the solution became rose pink. The acid value was calculated by the following formula (in units of mgKOH/g)

$$\text{Acid value (mgKOH/g)} = (5.611 \times a \times F)/S$$

where S: Amount of sample collected (g)
a: Amount of 0.1N alcoholic potassium hydroxide solution consumed (mL)
F: Titer of 0.1N alcoholic potassium hydroxide solution

<Measurement method of amine value>

Approximately 1g of sample was precisely measured into a stoppered Erlenmeyer flask, 100mL of cyclohexanone solution was added to dissolve the sample. Further, 2 or 3 drops of indicator prepared by mixing a solution made by dissolving 0.20g of methyl orange in 50mL of distillated water and a solution made by dissolving 0.28g of xylene cyanol FF in 50mL of methanol and sustained for 30 seconds. After that, titration was performed with 0.1N alcoholic potassium hydroxide solution until the solution became blue-gray. The amine value was calculated by the following formula (in units of mgKOH/g)

$$\text{Acid value (mgKOH/g)} = (5.611 \times a \times F)/S$$

where S: Amount of sample collected (g)
a: Amount of 0.1N alcoholic potassium hydroxide solution consumed (mL)
F: Titer of 0.1N alcoholic potassium hydroxide solution

<Measurement method of mass-average molecular weight (Mw)>

GPC (gel permeation chromatography) "GPC-101" manufactured by Showadenkosha. Co., Ltd. was used for measurement of Mw. GPC is liquid chromatography for separation and quantification of a substance dissolved in a solvent (THF; tetrahydrofuran) by a difference in molecular size. Measurement in the present invention was done by using two "KF-805L" (manufactured by Showadenkosha. Co., Ltd.: GPC column: 8mmIDx300mm) connected in series in the column, under the conditions with a sample concentration of 1wt%, a flow rate of 1.0ml/min, a pressure of 3.8MPa and a column temperature of 40°C, and the determination of the mass-average molecular weight (Mw) was made by polystyrene conversion. For data analysis, a calibration curve, a molecular weight and a peak area were calculated with use of manufacturer’s built-in software, and the mass-average molecular weight was calculated for the range of a hold time of 17.9 to 30.0 minutes as a target of analysis.

<Measurement method of glass-transition temperature of polyimide>

For the polyamide (A) where a solvent was dried and removed, "DSC-1" manufactured by Mettler-Toledo International Inc. was used, approximately 5mg of sample was weighed into an aluminum standard container, measurement was made in the range of -80° to 200°C under the conditions with a temperature-modulated amplitude of ±1°C, a temperature-modulated period of 60 seconds and a temperature rising rate of 2°C/minute, and the glass-transition temperature was calculated from a differential calorie curve, which is a reversible component.

<Synthesis of polyamide>

[Synthesis example 1] 202.9g (0.35mol by dibasic acid conversion) of Pripol 1009 as a polybasic acid compound with a carbon number of 36, 25.7g (0.14mol) of 5-hydroxyisophthalic acid as a polybasic acid compound having a phenolic hydroxyl group, 35.1g (0.21mol) of terephthalic acid as another polybasic acid compound, 313.9g (0.59mol by diamine

conversion) of Priamine 1074 as a polyamine compound with a carbon number of 36, and 100g of ion-exchanged water were charged into a 4-neck flask provided with a stirrer, a reflux cooling tube, a nitrogen injector, an injector and a thermometer, and stirred until a heating temperature became uniform. After the temperature was stabilized, it was raised to 110°C, outflow of water was checked and then the temperature was raised to 120°C after 30 minutes, and, after that, dehydration reaction was continued, raising the temperature by 10°C each every 30 minutes. When the temperature reached 230°C, the reaction was continued for 3 hours at the same temperature, kept for 1 hour under about 2kPa vacuum to lower the temperature. Finally, an anti-oxidant was added, and thereby the phenolic hydroxyl group-containing polyamide (A-1) with a mass-average molecular weight of 9800, an acid value of 22.8 mgKOH/g, an amine value of 0.3 mgKOH/g, a phenolic hydroxyl value of 13.7 mgKOH/g and a glass-transition temperature of 4°C was obtained. Note that, out of 100 mol% of all monomers used for reaction, monomers having a C20-60 hydrocarbon group were 72.7 mol%.

[Synthesis examples 2 to 19] Synthesis was made according to the composition and the charged parts by mass of Tables 1 and 2 by the same method as Synthesis example 1, and thereby the phenolic hydroxyl group-containing polyamide (A-1) having a C20-60 hydrocarbon group was obtained. The characteristic values are shown in Tables 1 and 2.

<Synthesis of polyamide ester>

[Synthesis example 20] 136.7g (0.24mol by dibasic acid conversion) of Pripol 1009 as a polybasic acid compound with a carbon number of 36, 10.9g (0.06mol) of 5-hydroxyisophthalic acid as a polybasic acid compound having a phenolic hydroxyl group, 200.2g (0.25mol) of Wandamin HM as another polyamine compound, and 100g of ion-exchanged water were charged into a 4-neck flask provided with a stirrer, a reflux cooling tube, a nitrogen injector, an injector and a thermometer, and stirred until a heating temperature became uniform. After the temperature was stabilized, it was raised to 110°C, outflow of water was checked and then the temperature was raised to 120°C after 30 minutes and, after that, dehydration reaction was continued, raising the temperature by 10°C each every 30 minutes. When the temperature reached 230°C, the reaction was continued for 3 hours at the same temperature, kept for 1 hour under about 2kPa vacuum to lower the temperature.

Then, when the inner temperature was reduced to 150°C, 3.5g (0.038mol by diol conversion) of Pripol 2033 as a polyol compound with a carbon number of 36 and 0.20g of tetrabutylorthotitanate were added, the temperature was raised again to 230°C, and it was kept for 1 hour under about 2kPa vacuum and further reacted for 2 to 3 hours under about 1kPa vacuum, and Finally, an anti-oxidant was added, and thereby the phenolic hydroxyl group-containing polyamide ester with a mass-average molecular weight of 38400, an acid value of 5.9 mgKOH/g, an amine value of 0.3 mgKOH/g, a phenolic hydroxyl value of 15.2 mgKOH/g and a glass-transition temperature of 25°C was obtained.

Note that, the amide/ester ratio was 6.5, and compounds having a C20-60 hydrocarbon group were 47.3 mol% out of 100 mol% of all monomers used for reaction.

[Synthesis examples 21 to 23] Synthesis was made according to the composition and the charged parts by mass of Table 3 by the same method as Synthesis example 20, and thereby the phenolic hydroxyl group-containing polyamide ester having a C20-60 hydrocarbon group was obtained. The characteristic values are shown in Table 3.

[Synthesis example 24] 48.6g (0.21mol) of dodecanedioic acid as another polybasic acid compound, 6.9g (0.03mol) of 4,4'-diamino-3,3'-dihydroxybiphenyl as a polyamine compound having a phenolic hydroxyl group, and 87.6g (0.42mol) of Wandamin HM as another amine compound, and 100g of ion-exchanged water were charged into a 4-neck flask provided with a stirrer, a reflux cooling tube, a nitrogen injector, an injector and a thermometer, and stirred until a heating temperature became uniform. After the temperature was stabilized, it was raised to 110°C, outflow of water was checked and then the temperature was raised to 120°C after 30 minutes and, after that, dehydration reaction was continued, raising the temperature by 10°C each every 30 minutes. When the temperature reached 230°C, the reaction was continued for 3 hours at the same temperature, kept for 1 hour under about 2kPa vacuum to lower the temperature. Finally, an anti-oxidant was added, and thereby the phenolic hydroxyl group-containing polyamide (a-1) with a mass-average molecular weight of 2800, an acid value of 0.5 mgKOH/g, an amine value of 185.8 mgKOH/g, a phenolic hydroxyl value of 25.1 mgKOH/g and a glass-transition temperature of 140°C was obtained.

Besides, 284.0g (0.49mol by dibasic acid conversion) of Pripol 1009 as a polybasic acid compound with a carbon number of 36, 102.7g (0.19mol by diamine conversion) of Priamine 1074 as a polyamine compound with a carbon number of 36, and 100g of ion-exchanged water were charged into a 4-neck flask provided with a stirrer, a reflux cooling tube, a nitrogen injector, an injector and a thermometer, and stirred until a heating temperature became uniform. After the temperature was stabilized, it was raised to 110°C, outflow of water was checked and then the temperature was raised to 120°C after 30 minutes and, after that, dehydration reaction was continued, raising the temperature by 10°C each every 30 minutes. When the temperature reached 230°C, the reaction was continued for 3 hours at the same temperature, kept for 1 hour under about 2kPa vacuum to lower the temperature. Finally, an anti-oxidant was added, and thereby the C20-60 hydrocarbon group-containing polyamide (a-2) with a mass-average molecular weight of 8800, an acid value of 87.4 mgKOH/g, an amine value of 0.3 mgKOH/g, and a glass-transition temperature of -30°C was obtained. Note that, out of 100 mol% of all monomers used for reaction, compounds having a C20-60 hydrocarbon group

were 51 mol%.

[Synthesis example 25] 121.3g of the phenolic hydroxyl group-containing polyamide (a-1) obtained in Synthesis example 24 and 380g of the C20-60 hydrocarbon group-containing polyamide (a-2) were charged into a 4-neck flask provided with a stirrer, a reflux cooling tube, a nitrogen injector, an injector and a thermometer, the temperature was raised to 110°C and further raised to 120°C after 30 minutes, and then dehydration reaction was continued, raising the temperature by 10°C each every 30 minutes. When the temperature reached 230°C, the reaction was continued for 3 hours at the same temperature, kept for 1 hour under about 2kPa vacuum to lower the temperature. Finally, an anti-oxidant was added, and thereby the phenolic hydroxyl group-containing polyamide ester with a mass-average molecular weight of 16600, an acid value of 13.6 mgKOH/g, an amine value of 0.4 mgKOH/g, a phenolic hydroxyl value of 6.9 mgKOH/g and a glass-transition temperature of 18°C was obtained.

[Comparative synthesis examples 1 to 2] Synthesis was made according to the composition and the charged parts by mass of Table 3 by the same method as Synthesis example 1. Comparative synthesis example 1 is a polyamide that does not have a phenolic hydroxyl group, and Comparative synthesis example 2 is a phenolic hydroxyl group-containing polyamide that does not have a C20-60 hydrocarbon group. The characteristic values are shown in Table 3.

[Comparative synthesis example 3] <Synthesis of polyurethane>

15.8 parts of thylene glycol, 5.3 parts of 1,6-hexanediol, 49.8 parts of toluene diisocyanate, 84.4 parts of toluene were charged into a 4-neck flask provided with a stirrer, a reflux cooling tube, a nitrogen injector, an injector and a thermometer, stirred and heated to 60°C under the nitrogen stream to dissolve uniformly. Then, 0.006 parts of dibutyltin dilaurate was injected thereto as a catalyst and reacted for 3 hours at 110°C. After that, the temperature was reduced, 5.5 parts of trimellitic anhydride and 238 parts of toluene were added, reacted for 3 hours at 110°C, and thereby polyurethane with a mass-average molecular weight of 14900, an acid value of 42.0 mgKOH/g, and a glass-transition temperature of 5.0°C was obtained.

[Comparative synthesis example 4] <Synthesis of phenolic hydroxyl group-containing polyester>

25.7 parts of 5-hydroxyisophthalic acid as a polybasic acid having a phenolic hydroxyl group, 82.4 parts of adipic acid as another polybasic acid, 332.3 parts of Pripol 2033 as polyol with a carbon number of 36, and 139.3 parts of toluene were charged into a 4-neck flask provided with a stirrer, a reflux cooling tube, a nitrogen injector, an injector and a thermometer, stirred and heated to 60°C under the nitrogen stream to dissolve uniformly. Then, 0.77 parts of tetrabutylorthotitanate was injected thereto as a catalyst and reacted for 3 hours at 110°C. After that, the temperature was raised to 230°C, and it was kept for 1 hour under about 2kPa vacuum and further reacted for 2 to 3 hours under about 1kPa vacuum, and Finally, an anti-oxidant was added, and thereby the phenolic hydroxyl group-containing polyester with a mass-average molecular weight of 9600, an acid value of 23.4 mgKOH/g, a phenolic hydroxyl value of 18.0 mgKOH/g and a glass-transition temperature of 34°C was obtained.

[Comparative synthesis example 5] <Synthesis of phenolic hydroxyl group-containing polyamide ester>

24.9g of isophthalic acid as another polybasic acid compound, 10.9g of 5-hydroxyisophthalic acid as a polybasic acid having a phenolic hydroxyl group, 78.5g of 1,6-hexanediol as another polyol compound, 5.2g of m-xylene diamine as another polyamine compound, 0.08g of tetrabutylorthotitanate, and 100g of ion-exchanged water were charged into a 4-neck flask provided with a stirrer, a reflux cooling tube, a nitrogen injector, an injector and a thermometer, and stirred until a heating temperature became uniform. After the temperature was stabilized, it was raised to 110°C, outflow of water was checked and then the temperature was raised to 120°C after 30 minutes, and, after that, dehydration reaction was continued, raising the temperature by 10°C each every 30 minutes. When the temperature reached 230°C, the reaction was continued for 3 hours at the same temperature to make reaction for 2 to 3 hours under about 2kPa vacuum, and Finally, an anti-oxidant was added, and thereby the phenolic hydroxyl group-containing polyamide ester with a mass-average molecular weight of 14600, an acid value of 15.5 mgKOH/g, an amine value of 0.3 mgKOH/g, a phenolic hydroxyl value of 30.6 mgKOH/g, a glass-transition temperature of 112°C, and an amide/ester ratio of 0.15 was obtained.

Table 1

| | | SYNTHESIS EXAMPLE1 | SYNTHESIS EXAMPLE2 | SYNTHESIS EXAMPLE3 | SYNTHESIS EXAMPLE4 | SYNTHESIS EXAMPLE5 | SYNTHESIS EXAMPLE6 | SYNTHESIS EXAMPLE7 | SYNTHESIS EXAMPLE8 | SYNTHESIS EXAMPLE9 | SYNTHESIS EXAMPLE10 |
|---|---|---|---|---|---|---|---|---|---|---|---|
| POLYBASIC ACID COMPOUND | CONTAINING C20-C60 HYDROCARBON GROUP | PRIPOL 1009 | PRIPOL 1004 | PRIPOL1009 | PRIPOL 1009 | PRIPOL 1009 | PRIPOL 1009 | PRIPOL 1009 | PRIPOL 1009 | | |
| | | 202.9 | 193.0 | 202.9 | 324.6 | 344.9 | 381.4 | 202.9 | 348.9 | | |
| | CONTAINING PHENOLIC HYDROXYL GROUP | 5-HIPA | 5-HIPA | 5-HIPA | 5-HIPA | 5-HIPA | 5-HIPA | 5-HIPA | 5-HIPA | 5-HIPA | 5-HIPA |
| | | 25.7 | 5.4 | 19.3 | 25.7 | 19.3 | 7.7 | 51.4 | 18.0 | 19.3 | 51.4 |
| | OTHER | TEREPHTHALIC ACID | ADIPIC ACID | ADIPIC ACID | | | | | | 1.4-CHDA | ISOPHTHALIC ACID |
| | | 35.1 | 56.7 | 36.1 | | | | | | 103.2 | 703 |
| POLYAMINE COMPOUND | CONTAINING C20-C60 HYDROCARBON GROUP | PRIAMINE 1074 | | PRIAMINE1071 | | PRIAMINE 1074 | PRIAMINE 1074 | PRIAMINE 1074 | PRIAMINE 1074 | PRIAMINE 1074 | PRIAMINE 1074 |
| | | 313.9 | | 78.9 | | 336.4 | 269.1 | 470.9 | 174.4 | 279.1 | 313.9 |
| | CONTAINING PHENOLIC HYDROXYL GROUP | | | | | | | | | | |
| | | | | | | | | | | | |
| | OTHER | | NBDA | NBDA | WANDAMIN HM | | NBDA | | WANDAMIN HM | | |
| | | | 120.8 | 82.9 | 138.6 | | 77.7 | | 68.7 | | |
| MASS-AVERAGE MOLECULAR WEIGHT | | 9800 | 3600 | 540000 | 21200 | 18600 | 4800 | 8200 | 23400 | 4400 | 7400 |
| ACID VALUE [mKO H/g] | | 22.8 | 0.2 | 9.0 | 10.6 | 12.1 | 0.4 | 0.4 | 9.6 | 51.1 | 30.3 |
| AMINE VALUE [mgKOH/g] | | 0.3 | 23.3 | 0.3 | 0.3 | 0.6 | 46.1 | 38.2 | 0.3 | 0.5 | 0.7 |
| PHENOLIC HYDROXYL VALUE [mgKOH/g] | | 13.7 | 5.2 | 14.1 | 16.2 | 8.5 | 3.2 | 21.8 | 9.1 | 14.8 | 36.3 |

(continued)

| | SYNTHESIS EXAMPLE1 | SYNTHESIS EXAMPLE2 | SYNTHESIS EXAMPLE3 | SYNTHESIS EXAMPLE4 | SYNTHESIS EXAMPLE5 | SYNTHESIS EXAMPLE6 | SYNTHESIS EXAMPLE7 | SYNTHESIS EXAMPLE8 | SYNTHESIS EXAMPLE9 | SYNTHESIS EXAMPLE10 |
|---|---|---|---|---|---|---|---|---|---|---|
| GLASS-TRANSITION TEMPERATURE [°C] | 4 | 32 | 35 | 50 | -30 | 4 | -30 | 42 | 13 | 34 |
| RATIO OF MONOMERS CONTAINING C20-C60 HYDROCARBON GROUP TO ALL MONOMERS [mol%] | 72.7 | 18.9 | 35.4 | 41.4 | 92.1 | 68.1 | 81.4 | 68.7 | 42.6 | 45.5 |

Table 2

| | | SYNTHESIS EXAMPLE11 | SYNTHESIS EXAMPLE12 | SYNTHESIS EXAMPLE13 | SYNTHESIS EXAMPLE14 | SYNTHESIS EXAMPLE15 | SYNTHESIS EXAMPLE16 | SYNTHESIS EXAMPLE17 | SYNTHESIS EXAMPLE18 | SYNTHESIS EXAMPLE19 |
|---|---|---|---|---|---|---|---|---|---|---|
| POLYBASIC ACD COMPOUNDS | CONTAINING C20-C60 HYDROCARBON GROUP | PRIPOL 1009 | PRIPOL 1009 | PRIPOL 1009 | PRIPOL 1009 | PRIPOL 1009 | PRIPOL 1004 | PRIPOL 1009 | PRIPOL 1009 | PRIPOL 1009 |
| | | 405.7 | 405.7 | 405.7 | 405.7 | 162.3 | 482.4 | 405.7 | 405.7 | 284.0 |
| | CONTAINING PHENOLIC HYDROXYL GROUP | | | | | | 5-HPA | | | |
| | | | | | | | 12.8 | | | |
| | OTHER | | | | | ADIPIC ACID | | | | DODECANDIOIC ACID |
| | | | | | | 61.8 | | | | 48.6 |
| POLYAMINE COMPOUND | CONTAINING C20-C60 HYDROCARBON GROUP | PRIAMINE 1074 | | | | | PRIAMINE 1074 | PRIAMINE 1074 | PRIAMINE 1074 | PRIAMINE 1074 |
| | | 267.7 | | | | | 297.4 | 125.6 | 167.4 | 102.7 |
| | CONTAINING PHENOLIC HYDROXYL GROUP | HAB | HAB | HAB | HAB | HAB | HAB | HAB | HAB | HAB |
| | | 46.4 | 76.2 | 72.6 | 27.0 | 26.0 | 13.4 | 10.2 | 16.9 | 6.9 |
| | OTHER | | WANDAMIN HM | MXDA | BISANILINE M | WANDAMIN HM | | IPDA | DPS | WANDAMIN HM |
| | | | 111.2 | 30.4 | 171.9 | 126.4 | | 32.0 | 97.3 | 87.6 |
| MASS-AVERAGE MOLECULAR WEIGHT | | 134200 | 6800 | 7000 | 15000 | 7800 | 18600 | 4800 | 17600 | 16600 |
| ACID VALUE [mgKOH/g] | | 0.0 | 0.5 | 32.1 | 15.1 | 0.3 | 21.9 | 46.0 | 0.3 | 13.6 |
| AMINE VALUE [mgKOH/g] | | 1.7 | 33.3 | 0.4 | 0.3 | 4.8 | 0.2 | 0.4 | 12.8 | 0.3 |
| PHENOLIC HYDROXYL VALUE [mgKOH/g] | | 33.5 | 66.7 | 74.0 | 23.2 | 35.8 | 13.5 | 9.2 | 12.8 | 6.8 |
| GLASS-TRANSITION TEMPERATURE [°C] | | -32 | 45 | 75 | 35 | 95 | 24 | 13 | 19 | 26 |

(continued)

| | SYNTHESIS EXAMPLE11 | SYNTHESIS EXAMPLE12 | SYNTHESIS EXAMPLE13 | SYNTHESIS EXAMPLE14 | SYNTHESIS EXAMPLE15 | SYNTHESIS EXAMPLE16 | SYNTHESIS EXAMPLE17 | SYNTHESIS EXAMPLE18 | SYNTHESIS EXAMPLE19 |
|---|---|---|---|---|---|---|---|---|---|
| RATIO OF MONOMERS CONTAINING C20-C60 HYDROCARBON GROUP TO ALL MONOMERS [mol%] | 34.9 | 44.4 | 55.8 | 53.1 | 19.8 | 90.5 | 80.0 | 68.4 | 51.0 |

Table 3

| | | SYNTHESIS EXAMPLE20 | SYNTHESIS EXAMPLE21 | SYNTHESIS EXAMPLE22 | SYNTHESIS EXAMPLE23 | COMPARATIVE SYNTHESIS EXAMPLE1 | COMPARATIVE SYNTHESIS EXAMPLE2 |
|---|---|---|---|---|---|---|---|
| POLYBASIC ACID COMPOUND | CONTAINING C20-C60 HYDROCARBON GROUP | PRIPOL 1009<br>136.7 | PRIPOL 1009<br>111.1 | PRIPOL 1009<br>102.5 | PRIPOL 1009<br>136.7 | PRIPOL 1009<br>324.6 | |
| | CONTAINING PHENOLIC HYDROXYL GROUP | 5-HIPA<br>10.9 | 5-HIPA<br>19.1 | | | | |
| | OTHER | | | ADIPIC ACID<br>17.5 | ISOPHTHALIC ACID<br>10.0 | ADIPIC ACID<br>20.6 | DODECANEDIOIC ACID<br>162.2 |
| POLYAMINE COMPOUND | CONTAINING C20-C60 HYDROCARBON GROUP | | | | | PRIAMINE 1074<br>342.5 | |
| | CONTAINING PHENOLIC HYDROXYL GROUP | | | | | | HAB<br>33.9 |
| | OTHER | WANDAMIN HM<br>200.2 | WANDAMIN HM<br>210.7 | WANDAMIN HM<br>194.7 | WANDAMIN HM<br>235.8 | | MXDA<br>35.2 |
| POLYOL COMPOUND | | PRIPOL2033<br>3.5 | C590<br>33.3 | PRIPOL2033<br>30.4 | C590<br>19.1 | | |
| MASS-AVERAGE MOLECULAR WEIGHT | | 38400 | 40600 | 21800 | 19800 | 21400 | 7200 |
| ACID VALUE [mgKOH/g] | | 5.9 | 5.5 | 10.3 | 11.3 | 10.5 | 0.6 |
| AMINE VALUE [mgKOH/g] | | 0.2 | 0.3 | 0.2 | 0.3 | 0.4 | 31.2 |
| PHENOLIC HYDROXYL VALUE [mgKOH/g] | | 15.2 | 21.2 | 13.7 | 7.0 | 0.0 | 32.5 |
| GLASS-TRANSITION TEMPERATURE [°C] | | 25 | 58 | 17 | -4 | -15 | 120 |
| AMIDE BOND/ESTER BOND MOL RATIO | | 3.5 | 1.1 | 1.3 | 1.9 | / | / |
| RATIO OF MONOMERS CONTAINING C20-C60 HYDROCARBON GROUP TO ALL MONOMERS [mol%] | | 47.3 | 51.2 | 51.8 | 42.0 | 39.5 | 0 |

The following conditions are common to Tables 1 to 3. Pripol 1009: Manufactured by Croda Japan KK., C36 dimer acid, including a compound having one cyclic structure with C6 (acid value: 195mgKOH/g) Pripol 1004: Manufactured by Croda japn KK, C44 dimer acid, including a coumpound having one cyclic structure with C6 (acid value: 164mgKOH/g) 1,4-CHDA: 1,4-Cyclohexanedicarboxylic acid 5-HIPA: 5-Hydroxyisophthalic acid MXDA: M-xylene diamine NBDA: Norbornanediamine Bisaniline M:Manufactured by Mitsui Fine Chemicals, Inc., aromatic diamine Wandamin HM:Manufactured by New Japan Chemical Co., Ltd., 4,4'-Diaminodicyclohexylmethane

Priamine 1074:Manufactured by Croda Japan KK., C36 dimerdiamine, including a compound having one cyclic structure with C6 (amine value: 210mgKOH/g)

Priamine 1071:Manufactured by Croda Japan KK., including a mixture of C36 dimerdiamine (having one cyclic structure with C6) and C54 trimer triamine (having one cyclic structure with C6) by 80:20 (mass ratio) (amine value: 198mgKOH/g)

IPDA: Isophoronediamine

DPS: 4,4'-Diaminodiphenyl sulfone

HAB: 4,4'-Diamino-3,3'-dihydroxybiphenyl

Pripol 2033: Manufactured by Croda Japan KK., C36 dimer diol, including a compound having one cyclic structure with C6 (OH value: 207mgKOH/g)

C590 : Manufacture by Kuraray Co.,Ltd., polycarbonate polyols

[Example 1] The phenolic hydroxyl group-containing polyamide (A) obtained by Synthesis example 1 was dissolved in a mixed solvent with toluene/IPA=50/50 (mass ratio) so as to have a solid content of 30%. In the solution containing 100 parts of the polyamide (A) described above, 20 parts of tetrakisphenol epoxy compound "1031s" (manufactured by Mitsubishi Chemical Corporation) was combined as the compound (B), and a mixed solvent with toluene/IPA=50/50 was added to have a solid content concentration of 25%, and thereby the thermosetting resin composition was obtained.

The thermosetting resin composition was uniformly applied onto a release-treated polyester film so that the film thickness after drying became 30μm and dried, and thereby an adhesive layer was prepared. Then, another release-treated polyester film was laminated on the adhesive layer side, and thereby an adhesive sheet with both side protective film was obtained. The physical properties and the performance of the thermosetting resin composition or the adhesive sheet obtained were evaluated by a method described later.

[Examples 2 to 25] The thermosetting resin composition and the adhesive sheet with both side protective film were obtained in the same manner as in Example 1 except that each of the phenolic hydroxyl group-containing polyamide (A) obtained by Synthesis examples 2 to 25, instead of the phenolic hydroxyl group-containing polyamide (A) obtained by Synthesis example 1, was used.

[Examples 26 to 47] The thermosetting resin composition and the adhesive sheet with both side protective film were obtained in the same manner as in Example 1 except that the compound (B) and the amount shown in Tables 7 to 9 was used, instead of the tetrakisphenol epoxy compound "1031s", for the phenolic hydroxyl group-containing polyamide (A) obtained by Synthesis example 8.

[Examples 48 to 63] The thermosetting resin composition and the adhesive sheet with both side protective film were obtained in the same manner as in Example 1 except that jER604 (manufactured by Mitsubishi Chemical Corporation), which is a multifunctional glycidyl amine compound, as an epoxy compound and TC401 (manufactured by Matsumoto Fine Chemical Co., Ltd.,) as a Ti chelate compound were used by the amounts shown in Tables 10 and 11, respectively, for the phenolic hydroxyl group-containing polyamide (A) obtained by Synthesis example 8 or Synthesis example 3.

[Examples 64 to 108] The thermosetting resin composition was obtained with the composition shown in Tables 12 to 16 in the same manner as in Example 1, and the adhesive sheet with both side protective film was prepared in the same manner as in Example 1.

[Comparative examples 1 to 5] The thermosetting resin composition and the adhesive sheet with both side protective film were obtained in the same manner as in Example 1 except that each of the resin obtained by Comparative synthesis examples 1 to 5 was used instead of the phenolic hydroxyl group-containing polyamide (A) obtained by Synthesis example 1.

[Comparative examples 6 to 15] The thermosetting resin composition and the adhesive sheet with both side protective film were obtained in the same manner as in Example 1 by using each of the resin obtained by Comparative synthesis examples 1 to 5 and with the composition shown in Table 18.

Note that, although the resin obtained by Comparative synthesis examples 2 and 5 was tried to be dissolved in a mixed solvent with toluene/IPA=50/50 (mass ratio) so as to have a solid content of 30%, the solubility was too poor to obtain a clear solution, and a part of the resin was precipitated.

[Comparative examples 16 to 24] In Comparative examples 16 to 21, the thermosetting resin composition was obtained in the same manner as in Example 1 except that each of the resin obtained by Comparative synthesis examples 2 and 4 was used, and the epoxy 5 was used instead of the compound (B) as a compound that can react with a phenolic hydroxyl group. In Comparative examples 22 to 24, the thermosetting resin composition was obtained in the same manner as in Example 1 except that the epoxy 5, instead of the compound (B), and the phenolic resin, which is described below, were used. Then, the adhesive sheet with both side protective film was obtained in the same manner as in Example 1.

The symbols shown in Tables 4 to 17 are as follows.

Epoxy 1: jER1031S, manufactured by Mitsubishi Chemical Corporation, tetrafunctional tetrakisphenol epoxy compound

Epoxy 2: jER604, manufactured by Mitsubishi Chemical Corporation, tetrafunctional multifunctional glycidyl amine compound

Epoxy 3: TETRAD-C, manufactured by Mitsubishi Gas Chemical Company, Inc., tetrafunctional multifunctional glycidyl amine compound

Epoxy 4: TETRAD-X, manufactured by Mitsubishi Gas Chemical Company, Inc., tetrafunctional multifunctional glycidyl amine compound
Epoxy 5: jER828, manufactured by Mitsubishi Chemical Corporation, bifunctional BisA epoxy compound
Chelate 1: Aluminum Chelate A, manufactured by Kawaken Fine Chemicals Co.,Ltd., trifunctional A1 chelate compound
Chelate 2: ALCH, manufactured by Kawaken Fine Chemicals Co.,Ltd., trifunctional A1 chelate compound
Chelate 3: TC401, manufactured by Matsumoto Fine Chemical Co., Ltd." tetrafunctional Ti chelate compound
Chelate 4: ZC700, manufactured by Matsumoto Fine Chemical Co., Ltd." tetrafunctional Zr chelate compound
Alkoxide 1: ASBD, manufactured by Kawaken Fine Chemicals Co.,Ltd., trifunctional 1 alkoxide compound
Alkoxide 2: TA-30, manufactured by Matsumoto Fine Chemical Co., Ltd., tetrafunctional Ti alkoxide compound
Alkoxide 3: ZA-65, manufactured by Matsumoto Fine Chemical Co., Ltd., tetrafunctional Zr alkoxide compound
Acylate: TC800, manufactured by Matsumoto Fine Chemical Co., Ltd., tetrafunctional Ti acylate compound
Isocyanate: BL3175, manufactured by Sumika Bayer Urethane Co., Ltd., trifunctional isocyanurate blocked isocyanate
Carbodiimide 1: V-07, manufactured by Nisshinbo Holdings Inc., multifunctional polycarbodiimide compound
Carbodiimide 2: V-03, manufactured by Nisshinbo Holdings Inc., multifunctional polycarbodiimide compound
Phenolic resin: TD2625, manufactured by DIC Corporation, multifunctional phenol novolac resin
Aziridine: Chemitite PZ33, manufactured by Nippon Shokubai Co., Ltd., trifunctional aziridine compound
DICY: Dicyandiamide
2E4MZ: 2-Ethyl-4-methylimidazole
TPP-K: manufactured by Hokko Chemical Industry Co., Ltd., phosphonium borate compound

The processability, adhesiveness, heat resistance, moist heat resistance, electrical insulating properties, flexibility, dielectric constant and dissipation factor of the adhesive sheet obtained by Examples and Comparative examples were evaluated by the following method.

<Evaluation>

(1) <Measurement method of glass-transition temperature of cured film>

A test sample was prepared by applyling the thermosetting resin composition onto a releasable film and drying it for 2 minutes at 100°C to have a thickness of about 30 μm. The test sample was cut into strips having a width of 5 mm and a length of 20 mm, and the viscoelasticity was measured by tensile mode at a temperature rising rate of 10°C/minute in the temperature range of -50°C to 300°C, with a tensile strain at a frequency of 10Hz, by using a viscoelasticity test machine (manufactured by IT Measurement Control Co., Ltd., DVA225), and a peak top temperature with a loss tangent of tanδ (loss elastic modulus E"/storage elastic modulus E') was obtained as the glass-transition temperature.

(2) Dimensional stability

An adhesive sheet with a size of 65mmx65mm from which protective films on both sides had been removed from the adhesive sheet with both side protective film was interposed between polyimide films "Kapton 300H" manufactured by Du Pont-Toray Co., Ltd. with a thickness of 75 μm, laminated at 80°C, and further thermocompressed for 30 minutes under the conditions at 160°C and 1.0MPa. Further, this test piece was thermally cured at 160°C for 2 hours, and thereby a test piece for evaluation was prepared. For this test piece, a difference in the area of the adhesive layer before pressure bonding and after heat curing was measured, and the processability was evaluated based on this difference as the excess area. The processability is to evaluate the degree of causing the displacement of a circuit board and the contact between lines due to the adhesive layer softened during thermocompression, and the results were evaluated by the following criteria.

aaa: Excess area ≤ $50mm^2$
aa: $50mm^2$ < Excess area ≤ $100mm^2$
a: $100mm^2$ < Excess area ≤ $250mm^2$
b: $250mm^2$ < Excess area ≤ $500mm^2$
c: $500mm^2$ < Excess area

(3) Adhesiveness

The test piece prepared by the evaluation of the dimensional stability was cut into strips of 10 mm in width and 65 mm in length, and a T peeling test was conducted at a tensile rate of 300mm/min under the atmosphere with a relative humidity of 50% at 23°C, and thereby the adhesion strength (N/cm) was measured. This test is to evaluate the adhesion strength of the adhesive layer during use at normal temperature, and the results were evaluated by the following criteria.

aa: 12(N/cm) < Adhesion strength
a: 8(N/cm) < Adhesion strength ≤ 12(N/cm)
b: 5(N/cm) < Adhesion strength ≤ 8(N/cm)
c: Adhesion strength ≤ 5(N/cm)

(4) Heat resistance

In the same manner as in the above (3), the test piece cut into strips of 10 mm in width and 65 mm in length was placed to float in a molten solder at 250°C or 270°C, with its polyimide film side in contact with the molten solder for one minute. After that, the appearance of the test piece was visually observed, and it was evaluated whether there are adhesion failures such as bubbles, floating and peeling in the adhesive layer. This test was to evaluate by appearance the thermal stability of the adhesive layer during a solder contact, and the appearance does not change before and after soldering if the heat resistance is improved; on the other hand, bubbles or peeling occurs after soldering if the heat resistance is low. The results were evaluated by the following criteria.

aa: No change in appearance
a: Few small bubbles are observed
b: Bubbles are observed
c: Many bubbles and peeling are observed

(5) Moist heat resistance

In the same manner as in the above (3), the test piece cut into strips of 10 mm in width and 65 mm in length was left under the atmosphere with a relative humidity of 90% at 40 °C for 72 hours to be moistened, and then placed under the atmosphere with a relative humidity of 50% at 23°C, and, in 1 minute, it is placed to float in a molten solder at 250°C, with its polyimide film side in contact with the molten solder for one minute. After that, the appearance of the test piece was visually observed, and it was evaluated whether there are adhesion failures such as bubbles, floating and peeling in the adhesive layer. This test was to evaluate by appearance the thermal stability of the adhesive layer in the moistened state during a solder contact, and the appearance does not change if the moist heat resistance is improved; on the other hand, bubbles or peeling occurs after soldering if the moist heat resistance is low. The results were evaluated by the following criteria.

aa: No change in appearance
a: Few small bubbles are observed
b: Bubbles are observed
c: Many bubbles and peeling are observed

(6) Electrical insulating properties

An adhesive sheet with a size of 65mmx65mm from which protective films on both sides had been removed from the adhesive sheet with both side protective film was interposed between a polyimide film [manufactured by Du Pont-Toray Co., Ltd., "Kapton 100H"] with a thickness of 25 μm and a comb pattern (conductor pattern width/space width = 50μm/50μm) printed circuit board where a copper circuit is formed on polyimide, laminated at 80 °C, and further thermocompressed for 30 minutes under the conditions at 160°C and 1.0MPa. Further, this test piece was thermally cured at 160°C for 2 hours, and thereby a test piece for evaluation was prepared. A direct voltage of 50V was continuously applied to a conductor circuit of this test piece for 100 hours under the atmosphere with a relative humidity of 85% at 130°C, and the insulation resistance value between conductors after 100 hours was measured under the atmosphere with a relative humidity of 50% at 23 °C. The evaluation criteria were as follows.

aa: Insulation resistance value is equal to or more than $10^8$ Ω
a: Insulation resistance value is equal to or more than $10^7$ and less than $10^8$ Ω

b: Insulation resistance value is equal to or more than $10^6$ and less than $10^7$ Ω
c: Insulation resistance value is less than $10^6$ Ω

(7) Flexibility

The thermosetting resin composition was uniformly applied onto a polyimide film [manufactured by Du Pont-Toray Co., Ltd., "Kapton 300H"] with a thickness of 75 μm so that the film thickness after drying became 30μm and dried, and further this test piece was thermally cured at 160°C for 2 hours, and thereby a test piece for evaluation was prepared. The test piece for evaluation was bent at 180 degrees with the cured coating side facing outward, and the state of the coating was evaluated by the following criteria.

a: No crack is seen on the coating surface
b: Slight crack is seen on the coating surface
c: The coating is broken up, and crack is clearly seen on the coating surface

(8) Dielectric constant

In the state where a large number of adhesive sheets from which protective films on both sides had been removed were interposed between adhesive sheets from which a protective film on one side had been removed from the adhesive sheet with both side protective film prepared by Examples and Comparative examples, vacuum lamination was carried out to prepare an adhesive sheet with a thickness of 1mm, and then it was thermally cured for 1 hour under the conditions at 160°C and 1.0MPa, and thereby a test piece for evaluation was prepared. The dielectric constant and the dissipation factor of this test piece at a measurement temperature of 23°C and a measurement frequency of 1GHz were calculated by a coaxial resonator method, using a dielectric measurement device manufactured by AET, Inc.

aa: Dielectric constant is equal to or less than 2.8
a: Dielectric constant is more than 2.8 and equal to or less than 3.0
b: Dielectric constant is more than 3.0 and equal to or less than 3.2
c: Dielectric constant is more than 3.2

(9) Dissipation factor

aa: The dissipation factor is equal to or less than 0.02
a: The dissipation factor is more than 0.02 and equal to or less than 0.03
b: The dissipation factor is more than 0.03 and equal to or less than 0.05
c: The dissipation factor is more than 0.05

Table 4

| | | EXAMPLE | | | | | | | | | |
|---|---|---|---|---|---|---|---|---|---|---|---|
| | | 1 | 2 | 3 | 4 | 5 | 6 | 7 | 8 | 9 | 10 |
| POLYAMIDE (A) | | SYNTHESIS EXAMPLE1 | SYNTHESIS EXAMPLE2 | SYNTHESIS EXAMPLE3 | SYNTHESIS EXAMPLE4 | SYNTHESIS EXAMPLE5 | SYNTHESIS EXAMPLE6 | SYNTHESIS EXAMPLE7 | SYNTHESIS EXAMPLE8 | SYNTHESIS EXAMPLE9 | SYNTHESIS EXAMPLE10 |
| | | 100 | 100 | 100 | 100 | 100 | 100 | 100 | 100 | 100 | 100 |
| COMPOUND (B) | | EPOXY1 | EPOXY1 | EPOXY1 | EPOXY1 | EPOXY1 | EPOXY1 | EPOXY1 | EPOXY1 | EPOXY1 | EPOXY1 |
| | | 10 | 10 | 10 | 10 | 10 | 10 | 10 | 10 | 10 | 10 |
| (1) GLASS TRANSITION TEMPERATURE[°C] | | 24 | 52 | 15 | 70 | -10 | 24 | -10 | 62 | 33 | 54 |
| (2) DIMENSIONAL STABLITY | | a | a | aa | a | a | b | a | a | b | a |
| (3) ADHESIVENESS | | aa | aa | aa | aa | aa | aa | aa | aa | aa | aa |
| (4) HEAT RESISTANCE(250°C) | | a | a | aa | a | a | b | a | a | a | a |
| (5) MOIST HEAT RESISTANCE | | a | a | a | a | a | b | a | a | a | a |
| (6) ELECTRICAL INSULATING PROPERTIES | | aa | aa | aa | aa | b | aa | b | aa | aa | aa |
| (7) BENDABILITY | | a | a | a | a | a | a | a | a | a | a |
| (8) DIELECTRIC CONSTANT | | a | a | a | a | a | a | a | a | a | a |
| (9) DISSIPATION FACTOR | | a | a | a | a | a | a | a | a | a | a |

TABLE 5

| | | EXAMPLE | | | | | | | | |
|---|---|---|---|---|---|---|---|---|---|---|
| | | 11 | 12 | 13 | 14 | 15 | 16 | 17 | 18 | 19 |
| POLYAMDE (A) | | SYNTHESIS EXAMPLE11 | SYNTHESIS EXAMPLE8 | SYNTHESIS EXAMPLE13 | SYNTHESIS EXAMPLE14 | SYNTHESIS EXAMPLE15 | SYNTHESIS EXAMPLE16 | SYNTHESIS EXAMPLES17 | SYNTHESIS EXAMPLE18 | SYNTHESIS EXAMPLE19 |
| | | 100 | 100 | 100 | 100 | 100 | 100 | 100 | 100 | 100 |
| COMPOUND (B) | | EPOXY1 | EPOXY1 | EPOXY1 | EPOXY1 | EPOXY1 | EPOXY1 | EPOXY1 | EPOXY1 | EPOXY1 |
| | | 10 | 10 | 10 | 10 | 10 | 10 | 10 | 10 | 10 |
| (1) GLASS-TRANSITION TEMPERATURE[°C] | | -12 | 65 | 95 | 55 | 115 | 44 | 33 | 39 | 46 |
| (2) DIMENSIONAL STABLITY | | a | a | aa | a | a | a | b | a | a |
| (3) ADHESIVENESS | | aa | aa | aa | aa | aa | aa | aa | aa | aa |
| (4) HEAT RESISTANCE(250°C) | | a | a | a | a | a | a | a | a | a |
| (5) MOIST HEAT RESISTANCE | | a | a | a | a | a | a | a | a | a |
| (6) ELECTRICAL INSULATING PROPERTIES | | b | aa | aa | aa | aa | aa | aa | aa | aa |
| (7) BENDABILITY | | b | a | a | a | b | a | a | a | a |
| (8) DIELECTRIC CONSTANT | | a | a | b | a | a | a | a | a | a |
| (9) DESPATDN FACTOR | | a | a | b | a | a | a | a | a | a |

Table 6

| | EXAMPLE | | | | | |
|---|---|---|---|---|---|---|
| | 20 | 21 | 22 | 23 | 24 | 25 |
| POLYAMIDE (A) | SYNTHESESIS EXAMPLE20 | SYNTHESIS EXAMPLE21 | SYNTHESESIS EXAMPLE22 | SYNTHESIS EXAMPLE23 | SYNTHESIS EXAMPLE24 | SYNTHESIS EXAMPLE25 |
| | 100 | 100 | 100 | 100 | 100 | 100 |
| COMPOUND (B) | EPOXY1 | EPOXY1 | EPOXY1 | EPOXY1 | EPOXY1 | EPOXY1 |
| | 10 | 10 | 10 | 10 | 10 | 10 |
| (1) GLASS-TRANSITION TEMPERATURE[°C] | 35 | 78 | 37 | 14 | 38 | 32 |
| (2) DIMENSIONAL STABLITY | a | a | a | a | b | a |
| (3) ADHESIVENESS | aa | aa | aa | aa | aa | aa |
| (4) HEAT RESISTANCE (250°C) | a | a | a | a | a | a |
| (5) MOIST HEAT RESISTANCE | a | a | a | a | a | a |
| (6) ELECTRICAL INSULATING PROPERTES | b | b | b | b | a | a |
| (7) BENDABILITY | a | a | a | a | a | a |
| (8) DIELECTRIC CONSTANT | a | a | a | a | a | a |
| (9) DISSIPATION FACTOR | a | a | a | a | a | a |

Table 7

| | EXAMPLE | | | | | | |
|---|---|---|---|---|---|---|---|
| | B | 26 | 27 | 28 | 29 | 30 | 31 |
| POLYAMIDE (A) | SYNTHESIS EXAMPLES | | | | | | |
| | 100 | | | | | | |
| COMPOUND (B) | EPOXY1 | EPOXY2 | EPOXY3 | EPOXY4 | ISOCYANATE | CARBO DIIMIDE1 | CARBO DIIMIDE2 |
| | 10 | 10 | 10 | 10 | 10 | 10 | 10 |
| (1) GLASS-TRANSITION TEMPERATURE [°C] | 62 | 63 | 65 | 64 | 58 | 64 | 65 |
| (2) DIMENSIONAL STABILITY | a | a | a | a | a | a | a |
| (3) ADHESIVENESS | aa | aa | aa | aa | a | aa | aa |
| (4) HEAT RESISTANCE (250°C) | a | a | a | a | a | a | a |
| (5) MOIST HEAT RESISTANCE | a | a | a | a | a | a | a |
| (6)ELECTRICAL INSULATING PROPERTIES | aa | aa | aa | aa | aa | a | a |
| (7) BENDABILITY | a | a | a | a | a | a | a |
| (8) DIELECTRIC CONSTANT | a | a | a | a | a | a | a |
| (9) DISSIPATION FACTOR | a | a | a | a | a | a | a |

Table 8

| | EXAMPLE | | | | | | | |
|---|---|---|---|---|---|---|---|---|
| | 32 | 33 | 34 | 35 | 36 | 37 | 38 | 39 |
| POLYAMIDE (A) | SYNTHESIS EXAMPLES | | | | | | | |
| | 100 | | | | | | | |
| COMPOUND (B) | CHELATE1 | CHELATE2 | CHELATE3 | CHELATE4 | ALKOXIDE1 | ALKOXIDE2 | ALKOXIDE3 | ACYLATE |
| | 10 | 10 | 10 | 10 | 10 | 10 | 10 | 10 |
| (1) GLASS-TRANSITION TEMPERATURE [°C] | 65 | 66 | 66 | 64 | 65 | 65 | 65 | 62 |
| (2) DMENSIONALSTABLITY | aa | aa | aa | aa | aa | aa | aa | aa |
| (3) ADHESIVENESS | a | a | a | a | b | b | b | b |
| (4) HEAT RESISTANCE (250°C) | a | a | aa | b | a | aa | b | aa |
| (5) MOIST HEAT RESISTANCE | a | a | a | b | a | a | b | a |
| (6) ELECTRICAL INSULATING PROPERTIES | a | a | a | a | a | a | a | a |
| (7) BENDABILITY | a | a | a | a | a | a | | a |
| (8) DIELACTRIC CONSTANT | aa | aa | aa | aa | aa | aa | aa | aa |
| (9) DISSIPATION FACTOR | aa | aa | aa | aa | aa | aa | aa | aa |

Table 9

| | EXAMPLE | | | | | | | |
|---|---|---|---|---|---|---|---|---|
| | 40 | 41 | 42 | 43 | 44 | 45 | 46 | 47 |
| POLYAMIDE (A) | SYNTHESIS EXAMPLES | | | | | | | |
| | 100 | | | | | | | |
| COMPOUND (B) | EPOXY2 | | | | CHELATE3 | | | |
| | 5 | 20 | 30 | 50 | 5 | 20 | 30 | 50 |
| (1) GLASS-TRANSITION TEMPERATURE[°C] | 60 | 64 | 65 | 70 | 63 | 67 | 70 | 74 |
| (2) DIMENSIONAL STABILITY | a | a | a | a | aa | aa | aa | aa |
| (3) ADHESIVENESS | aa | aa | aa | aa | a | a | a | a |
| (4) HEAT RESISTANCE(250°C) | a | a | a | a | a | a | a | a |
| (5) MOIST HEAT RESISTANCE | a | a | a | b | a | a | a | b |
| (6) ELECTRICAL INSULATING PROPERTIES | b | a | a | a | a | a | a | a |
| (7) BENDABILITY | a | a | a | a | a | a | a | a |
| (8) DIELECTRIC CONSTANT | aa | a | a | b | aa | aa | aa | a |
| (9)DISSIPATION FACTOR | a | a | a | b | aa | aa | aa | a |

Table 10

| | EXAMPLE | | | | | | | |
|---|---|---|---|---|---|---|---|---|
| | 48 | 49 | 50 | 51 | 52 | 53 | 54 | 55 |
| POLYAMIDE (A) | SYNTHESIS EXAMPLE8 | | | | | | | |
| | 100 | | | | | | | |
| COMPOUND (B) | EPOXY2 | | | | EPOXY2 | | | |
| | 10 | | | | 5 | 5 | 10 | 20 |
| | CHELATE 1 | CHELATE2 | CHELATE3 | CHELATE4 | CHELATE3 | | | |
| | 5 | 5 | 5 | 5 | 5 | 10 | 10 | 10 |
| (1) GLASS-TRANSITION TEMPERATURE[°C] | 65 | 64 | 65 | 64 | 62 | 67 | 65 | 68 |
| (2) DIMENSION STABILITY | aa | aa | aa | aa | aa | aa | aa | aa |
| (3) ADHESIVENESS | aa | aa | aa | aa | aa | aa | aa | aa |
| (4) HEAT RESISTANCE (250°C) | a | a | aa | b | aa | aa | aa | aa |
| (4) HEAT RESISTANCE (270°C) | a | a | a | b | a | a | a | a |
| (5) MOIST HEAT RESISTANCE | a | a | a | b | a | a | a | a |
| (6) ELECTRICAL INSULATING PROPERTIES | aa | aa | aa | aa | aa | aa | aa | aa |
| (7) BENDABILITY | a | a | a | a | a | a | a | a |

(continued)

| | EXAMPLE | | | | | | | |
|---|---|---|---|---|---|---|---|---|
| | 48 | 49 | 50 | 51 | 52 | 53 | 54 | 55 |
| (8) DIELECTRIC CONSTANT | aa | aa | aa | aa | aa | aa | aa | aa |
| (9) DISSIPATION FACTOR | aa | aa | aa | aa | aa | aa | aa | aa |

Table 11

| | EXAMPLE | | | | | | | |
|---|---|---|---|---|---|---|---|---|
| | 56 | 57 | 58 | 59 | 60 | 61 | 62 | 63 |
| POLYAMIDE (A) | SYNTHESIS EXAMPLE3 | | | | | | | |
| | 100 | | | | | | | |
| COMPOUND (B) | EPOXY2 | | | | EPOXY2 | | | |
| | 10 | | | | 5 | 5 | 10 | 20 |
| | CHELATE1 | CHELATE2 | CHELATE3 | CHELATE4 | CHELATE3 | | | |
| | 5 | 5 | 5 | 5 | 5 | 10 | 10 | 10 |
| (1) GLASS-TRANSITION TEMPERATURE[°C] | 58 | 57 | 58 | 57 | 55 | 60 | 58 | 61 |
| (2) DIMENSION STABILITY | aaa | aaa | aaa | aaa | aaa | aaa | aaa | aaa |
| (3) ADHESIVENESS | aa | aa | aa | aa | aa | aa | aa | aa |
| (4) HEAT RESISTANCE (270°C) | aa | aa | aa | aa | aa | aa | aa | aa |
| (5) MOIST HEAT RESISTANCE | a | a | a | a | a | a | a | a |
| (6) ELECTRICAL INSULATING PROPERTIES | aa | aa | aa | aa | aa | aa | aa | aa |
| (7) BENDABILITY | a | a | a | a | a | a | a | a |
| (8) DIELECTRIC CONSTANT | aa | aa | aa | aa | aa | aa | aa | aa |
| (9) DISSIPATION FACTOR | aa | aa | aa | aa | aa | aa | aa | aa |

Table 12

| | | EXAMPLE | | | | | | | | | |
|---|---|---|---|---|---|---|---|---|---|---|---|
| | | 64 | 65 | 66 | 67 | 68 | 69 | 70 | 71 | 72 | 73 |
| POLYAMIDE (A) | | SYNTHESIS EXAMPLE1 | SYNTHESIS EXAMPLE2 | SYNTHESIS EXAMPLE3 | SYNTHESIS EXAMPLE4 | SYNTHESIS EXAMPLE5 | SYNTHESIS EXAMPLE6 | SYNTHESIS EXAMPLE7 | SYNTHESIS EXAMPLE8 | SYNTHESIS EXAMPLE9 | SYNTHESIS EXAMPLE10 |
| | | 100 | 100 | 100 | 100 | 100 | 100 | 100 | 100 | 100 | 100 |
| COMPOUND (B) | | EPOXY2 | EPOXY3 | ISOCYANATE | CARBODII MIDE1 | CHELATE1 | ISOCYANATE | EPOXY4 | CHELATE3 | CARBOII MIDE2 | CHELATE4 |
| | | 10 | 40 | 15 | 5 | 10 | 5 | 25 | 25 | 20 | 5 |
| (1) GLASS-TRANSI-TION TEMPERA-TURE[°C] | | 24 | 52 | 13 | 72 | -6 | 21 | -10 | 65 | 37 | 58 |
| (2) DIMENSIONAL STABILITY | | a | a | aa | aa | aa | b | a | a | b | aa |
| (3) ADHESIVENESS | | aa | aa | a | aa | a | a | aa | a | aa | a |
| (4) HEAT RESISTANCE(250°C) | | a | a | aa | a | a | b | a | a | a | b |
| (5) MOIST HEAT RESISTANCE | | a | a | a | a | a | b | a | a | a | b |
| (6) ELECTRICAL IN-SULATING PROPER-TIES | | aa | aa | a | a | b | a | b | a | a | a |
| (7) BENDABILITY | | a | a | a | a | a | a | a | a | a | a |
| (8) DIELECTRIC CONSTANT | | a | aa | aa | aa | a | aa | a | a | a | aa |
| (9) DISSIPATION FACTOR | | a | b | a | a | aa | a | a | aa | a | aa |

Table 13

| | EXAMPLE | | | | | | | | | |
|---|---|---|---|---|---|---|---|---|---|---|
| | 74 | 75 | 76 | 77 | 78 | 79 | 80 | 81 | 82 | 83 |
| POLYAMIDE (A) | SYNTHESIS EXAMPLE11 | SYNTHESIS EXAMPLE12 | SYNTHESIS EXAMPLE13 | SYNTHESIS EXAMPLE14 | SYNTHESIS EXAMPLE15 | SYNTHESIS EXAMPLE16 | SYNTHESIS EXAMPLE17 | SYNTHESIS EXAMPLE18 | SYNTHESIS EXAMPLE19 | SYNTHESIS EXAMPLE20 |
| | 100 | 100 | 100 | 100 | 100 | 100 | 100 | 100 | 100 | 100 |
| COMPOUND (B) | ALKOXIDE2 | EPOXY1 | EPOXY4 | ISOCYANATE | CARBODII MIDE1 | ALKOXIDE1 | EPOXY4 | EPOXY2 | ISOCYANATE | CARBODII MIDE 1 |
| | 10 | 30 | 50 | 35 | 20 | 15 | 25 | 10 | 15 | 20 |
| (1) GLASS-TRANSI-TION TEMPERA-TURE[°C] | -10 | 65 | 95 | 53 | 117 | 45 | 39 | 33 | 42 | 37 |
| (2) DIMENSIONAL STABILITY | aa | aa | a | a | aa | aa | b | a | a | aa |
| (3) ADHESIVENESS | b | aa | aa | a | aa | b | aa | aa | a | aa |
| (4) HEAT RESISTANCE (250°C) | a | a | a | a | a | a | a | a | a | a |
| (5) MOST HEAT RESISTANCE | a | a | b | a | a | a | a | a | a | a |
| (6) ELECTRICAL IN-SULATING PROPER-TIES | b | aa | aa | a | a | a | aa | aa | a | b |
| (7) BENDABILITY | a | b | a | a | b | a | a | a | a | a |
| (8) DIELECTRIC CONSTANT | aa | b | b | a | aa | aa | b | a | a | a |
| (9) DISSIPATION FACTOR | aa | b | b | a | a | aa | b | a | a | a |

Table 14

| | EXAMPLE | | | | |
|---|---|---|---|---|---|
| | 84 | 85 | 86 | 87 | 88 |
| POLYAMIDE (A) | SYNTHESIS EXAMPLE21 | SYNTHESIS EXAMPLE22 | SYNTHESIS EXAMPLE23 | SYNTHESIS EXEMPLE24 | SYNTHESIS EXEMPLE25 |
| | 100 | 100 | 100 | 100 | 100 |
| COMPOUND (B) | ISOCYANATE | ALKOXIDE2 | ALKOXIDE2 | ISOCYANATE | ISOCYANATE |
| | 15 | 10 | 25 | 15 | 15 |
| (1) GLASS-TRANSITION TEMPERATURE [°C] | 76 | 39 | 16 | 35 | 30 |
| (2) DIMENSIONAL STABILITY | a | aa | aa | b | a |
| (3) ADHESIVENESS | a | b | b | aa | a |
| (4) HEAT RESISTANCE (250°C) | a | a | a | a | a |
| (5) MOIST HEAT REETANCE | a | a | a | a | a |
| (6) ELECTRICAL INSULATING PROPERTIES | b | b | b | a | a |
| (7) BENDABILITY | a | a | a | a | a |
| (8) DIELECTRIC CONSTANT | a | aa | aa | a | a |
| (9) DISSIPATION FACTOR | a | aa | aa | a | a |

Table 15

| | EXAMPLE | | | | | | | | | |
|---|---|---|---|---|---|---|---|---|---|---|
| | 89 | 90 | 91 | 92 | 93 | 94 | 95 | 96 | 97 | 98 |
| POLYAMIDE (A) | SYNTHESIS EXAMPLE1 | SYNTHESIS EXAMPLE2 | SYNTHESIS EXAMPLE3 | SYNTHESIS EXAMPLE4 | SYNTHESIS EXAMPLE5 | SYNTHESIS EXAMPLE6 | SYNTHESIS EXAMPLE7 | SYNTHESIS EXAMPLE8 | SYNTHESIS EXEMPLE9 | SYNTHESIS EXAMPLE10 |
| | 100 | 100 | 100 | 100 | 100 | 100 | 100 | 100 | 100 | 100 |
| COMPOUND (B) | EPOXY1 | GARBODII MIDE1 | EPOXY3 | CARBODII MIDE1 | EPOXY1 | EPOXY2 | EPOXY1 | EPOXY1 | EPOXY1 | EPOXY3 |
| | 20 | 20 | 20 | 15 | 15 | 3 | 25 | 15 | 5 | 15 |
| | CHELATE1 | EPOXY1 | ALKOXIDE1 | EPOXY1 | | | | ALKOXIDE 1 | | CHELATE4 |
| | 10 | 10 | 10 | 15 | | | | 5 | | 5 |
| COMPOUND THAT CAN REACT WITH CARBOXYL GROUP | | | | | AZIRIDINE | DICY | | | | |
| | | | | | 5 | 2 | | | | |
| ACCELERATOR | | | | | | | 2E4MZ | | TPP-K | |
| | | | | | | | 5 | | 10 | |
| (1) GLASS-TRANSITION TEMPERATURE[°C] | 26 | 55 | 19 | 74 | -B | 29 | -2 | 60 | 34 | 5B |
| (2) DIMENSIONAL STABILITY | aa | aa | aa | aa | aa | b | a | aa | b | aa |
| (3) ADHESIVENESS | aa | aa | a | aa | aa | aa | aa | aa | aa | aa |
| (4) HEAT RESISTANCE (250°C) | aa | a | aa | a | aa | b | aa | a | aa | a |
| (5) MOIST HEAT RESISTANCTE | aa | a | aa | a | aa | b | aa | a | aa | a |
| (6) ELECTRICAL INSULATING PROPERTIES | aa | aa | aa | aa | aa | a | b | aa | aa | aa |
| (7) BENDABILITY | a | a | a | a | a | a | a | a | a | b |

(continued)

| | EXAMPLE | | | | | | | | | |
|---|---|---|---|---|---|---|---|---|---|---|
| | 89 | 90 | 91 | 92 | 93 | 94 | 95 | 96 | 97 | 98 |
| (8) DIELECTRIC CONSTANT | aa | aa | aa | a | a | aa | a | aa | a | aa |
| (9) DISSIPATION FACTOR | aa | a | aa | a | a | a | a | aa | a | aa |

Table 16

| | | EXAMPLE | | | | | | | | | |
|---|---|---|---|---|---|---|---|---|---|---|---|
| | | 99 | 100 | 101 | 102 | 103 | 104 | 105 | 106 | 107 | 108 |
| POLYAMIDE (A) | | SYNTHESIS EXAMPLE11 | SYNTHESIS EXAMPLE12 | SYNTHESIS EXAMPLE13 | SYNTHESIS EXAMPLE14 | SYNTHESI EXAMPLE15 | SYNTHESIS EXAMPLE16 | SYNTHESIS EXAMPLE17 | SYNTHESIS EXAMPLE18 | SYNTHESIS EXAMPLE19 | SYNTHESIS EXAMPLE20 |
| | | 100 | 100 | 100 | 100 | 100 | 100 | 100 | 100 | 100 | 100 |
| COMPOUND (B) | | EPOXY3 | ISOCYANATE | ISOCYANATE | EPOXY2 | EPOXY4 | EPOXY1 | EPOXY1 | EPOXY1 | EPOXY1 | ISOCYANATE |
| | | 15 | 25 | 35 | 25 | 30 | 25 | 15 | 30 | 15 | 20 |
| | | CHELATE2 | ALKOXIDE2 | CARBODIIMIDE1 | ACYLATE | | GARBODIIMIDE2 | ALKOXIDE1 | | ALKOXIDE1 | ALKOXIDE1 |
| | | 5 | 15 | 15 | 10 | | 5 | 5 | | 5 | 5 |
| ACCELERATOR | | | | | | 2E4MZ | | | 2E4MZ | | |
| | | | | | | 10 | | | 5 | | |
| (1) GLASS-TRANSITION TEMPERATURE[°C] | | -8 | 68 | 102 | 61 | 124 | 46 | 44 | 36 | 48 | 38 |
| (2) DIMENSIONAL STABILITY | | aa | aa | aa | aa | a | aa | aa | a | a | aa |
| (3) ADHESIVENESS | | aa | a | aa | aa | aa | aa | aa | aa | aa | a |
| (4) HEAT RESISTANCE (250°C) | | aa | a | a | aa | aa | a | a | a | a | a |
| (5) MOIST HEAT RESISTANCE | | aa | a | a | a | aa | aa | a | b | a | a |
| (6) ELECTRICAL INSULATING PROPERTIES | | b | a | a | aa | aa | aa | aa | aa | aa | b |
| (7) BENDABILITY | | a | a | a | a | b | a | a | a | a | a |
| (8) DIELECTRIC CONSTANT | | aa | a | b | aa | a | aa | aa | b | aa | aa |
| (9) DISSIPATION FACTOR | | aa | a | b | aa | b | a | aa | b | aa | aa |

Table 17

| | COMPARATIVE EXAMPLE | | | | |
|---|---|---|---|---|---|
| | 1 | 2 | 3 | 4 | 5 |
| OTHER RESIN | COMPARATIVE SINTHESIS EXAMPLE1 | COMPARATIVE SYNTHESIS EXAMPLE2 | COMPARATIVE SYNTHESIS EXAMPLE3 | COMPARATIVE SYNTHESIS EXAMPLE4 | COMPARATIVE SYNTHESIS EXAMPLE5 |
| | 100 | 100 | 100 | 100 | 100 |
| COMPOUND (B) | EPOXY1 | EPOXY1 | EPOXY1 | EPOXY1 | EPOXY1 |
| | 10 | 10 | 10 | 10 | 10 |
| (1) GLASS-TRANSITION TEMPERATURE[°C] | -15 | 120 | 5 | 34 | 112 |
| (2) DIMENSIONAL STABILITY | c | a | c | a | a |
| (3) ADHESIVENESS | aa | aa | a | a | aa |
| (4) HEAT RESISTANCE (250°C) | c | b | c | a | b |
| (5) MOIST HEAT RESISTANCE | c | c | c | a | c |
| (6) ELECTRICAL INSULATING PROPERTIES | c | aa | c | c | c |
| (7) BENDABILITY | a | b | a | a | a |
| (8) DIELECTRIC CONSTANT | a | c | c | a | c |
| (9) DISSIPATION FACTOR | a | c | c | a | c |

Table 18

| | COMPARATIVE EXAMPLE | | | | | | | | | |
|---|---|---|---|---|---|---|---|---|---|---|
| | 6 | 7 | 8 | 9 | 10 | 11 | 12 | 13 | 14 | 15 |
| OTHER RESIN | COMPARA-TIVE SYN-THESIS EXAMPLE1 | COMPARA-TIVE SYN-THESIS EXAMPLE2 | COMPARA-TIVE SYNTE-SIS EXAMPLE3 | COMPARA-TIVE SYN-THESIS EXAMPLE4 | COMPARA-TIVE SYN-THESIS EXAMPLE5 | COMPARA-TIVE SYN-THESIS EXAMPLE1 | COMPARA-TIVE SYN-THESIS EXAMPLE2 | COMPARA-TIVESYNTHE EXAMPLE3 | COMPARA-TIVE SIS EXAMPLE4 | COMPARA-TIVE SYN-THESIS EXAMPLE5 |
| | 100 | 100 | 100 | 100 | 100 | 100 | 100 | 100 | | 100 |
| COMPOUND (B) | CARBODII MIDE1 | EPOXY2 | EPOXY1 | CHELATE2 | CHELATE3 | EPOXY1 | EPOXY1 | EPOXY2 | ISOCYANATE | CARBODII MIDE1 |
| | 20 | 20 | 20 | 15 | 30 | 15 | 15 | 20 | 30 | 15 |
| | | | | | | CHELATE3 | | | CHELATE2 | ISOCYANATE |
| | | | | | | 5 | | | 5 | 5 |
| COMPOUND THAT CAN RE-ACT WITH CAR-BOXYL GROUP | | | | | | | AZIRIDINE | | | |
| | | | | | | | 5 | | | |
| ACCELERATOR | | | | | | | | 2E4MZ | | |
| | | | | | | | | 5 | | |
| (1) GLASS-TRAN-SITION TEMPER-ATURE[°C] | -14 | 121 | 6 | 38 | 114 | -11 | 125 | 8 | 36 | 114 |
| (2) DIMENSIONAL STABILITY | c | a | c | aa | aa | c | aa | c | aa | aa |
| (3) ADHESIVENESS | aa | aa | a | a | a | aa | aa | a | a | aa |
| (4) HEAT RESISTANCE (250°C) | c | c | c | a | c | c | c | c | 8 | c |
| (5) MOIST HEAT RESISTANCE | c | c | c | a | c | c | c | c | a | c |

(continued)

| | COMPARATIVE EXAMPLE | | | | | | | | | |
|---|---|---|---|---|---|---|---|---|---|---|
| | 6 | 7 | 8 | 9 | 10 | 11 | 12 | 13 | 14 | 15 |
| (6) ELECTRICAL INSULATING PROPERTIES | c | aa | c | c | c | c | aa | c | c | c |
| (7) BENDABILITY | a | a | a | a | a | a | 8 | a | a | a |
| (8) DIELECTRIC CONSTANT | a | c | c | a | c | aa | c | c | aa | c |
| (9) DISSIPATION FACTOR | a | c | c | a | c | aa | c | c | aa | c |

Table 19

| | | COMPARATIVE EXAMPLE | | | | | | | | |
|---|---|---|---|---|---|---|---|---|---|---|
| | | 16 | 17 | 18 | 19 | 20 | 21 | 22 | 23 | 24 |
| POLYAMIDE (A) | | SYNTHESIS EXAMPLE4 | SYNTHESIS EXAMPLE4 | SYNTHESIS EXAMPLE4 | SYNTHESIS EXAMPLE4 | SYNTHESIS EXAMPLE4 | SYNTHESIS EXAMPLE2 | SYNTHESIS EXAMPLE4 | SYNTHESIS EXAMPLE4 | SYNTHESIS EXAMPLE4 |
| | | 100 | 100 | 100 | 100 | 100 | 100 | 100 | 100 | 100 |
| OTHER ADDITIVE | | EPOXY5 | EPOXY5 | EPOXY5 | EPOXY5 | EPOXY5 | EPOXY5 | EPOXY5 | EPOXY5 | EPOXY5 |
| | | 10 | 20 | 30 | 40 | 50 | 40 | 40 | 40 | 40 |
| | | | | | | | | PHENOLIC RESIN | PHENOLIC RESIN | PHENOLIC RESIN |
| | | | | | | | | 40 | 60 | 80 |
| (1) GLASS-TRANSITION TEMPERATURE[°C] | | 68 | 69 | 71 | 72 | 73 | 50 | 128 | 142 | 155 |
| (2) DIMENSIONAL STABILITY | | c | c | c | c | c | c | 8 | a | a |
| (3) ADHESIVENESS | | aa | aa | aa | aa | aa | aa | a | a | a |
| (4) HEAT RESISTANCE (250°C) | | c | c | c | c | c | c | a | a | a |
| (5) MOIST HEAT RESISTANCE | | c | c | c | c | c | c | a | a | a |
| (6) ELECTRICAL INSULATING PROPERTIES | | c | c | c | c | c | c | a | a | a |
| (7) BENDABILITY | | a | a | a | a | a | a | c | c | c |
| (8) DIELECTRIC CONSTANT | | a | a | a | a | a | a | c | c | c |
| (9) DESPATDN FACTOR | | a | a | a | a | a | a | c | c | c |

In Comparative examples 1, 6 and 11 which use the polyamide in Comparative synthesis example 1 that does not have a phenolic hydroxyl group in the polyamide, the dimensional stability, the heat resistance, the moist heat resistance and the electrical insulating properties of the adhesive sheet are significantly deteriorated (see Tables 17 and 18).

Further, the polyamides in Comparative synthesis examples 2 and 5 that does not have a monomer containing a C20-60 hydrocarbon group has poor solubility, and therefore, in Comparative examples 2, 5, 7, 10, 12 and 15 that use those polyamides, a uniform adhesive sheet cannot be formed, and the moist heat resistance, the dielectric constant and the dissipation factor are significantly deteriorated.

The adhesive sheets in Comparative examples 4, 9 and 14 which use the resin obtained by Comparative synthesis example 4 that contains a large number of polyester bonds instead of amide bonds have significantly low insulation reliability.

Further, in Comparative examples 3, 8 and 13 which use the polyurethane resin in Comparative synthesis example 3 that does not have any of a phenolic hydroxyl group, a structure represented by a hydrocarbon group with a carbon number of 20 to 60 and an amide bond, the dimensional stability, the heat resistance, the moist heat resistance, the electrical insulating properties, the dielectric constant and the dissipation factor are significantly deterioratedd.

In addition, in Comparative examples 16 to 21 which use bifunctional epoxy, even with use of polyamide resin having all of a phenolic hydroxyl group, a structure represented by a hydrocarbon group with a carbon number of 20 to 60 and an amide bond, the dimensional stability, the heat resistance, the moist heat resistance and the electrical insulating properties are significantly low because the crosslink density of a coating is not high enough. Further, in Comparative examples 22 to 24 which use two types of curing agents, bifunctional epoxy and multifunctional phenolic resin, in combination, suitable effects are obtained for the dimensional stability, the heat resistance and the moist heat resistance because the multifunctional phenolic resin is used; however, the flexibility is significantly lowered because it contains a large number of aromatic rings with high TG-raising effect and the crosslink density is high, and the dielectric constant and the dissipation factor are significantly deteriorated (the low dielectric properties and the low dissipation factor properties are not exhibited) because it has a high polarity phenolic functional group derived from phenol with high density.

On the other hand, the polyamide used in Examples is made by the polymerization using monomers containing a phenolic hydroxyl group and a C20-60 hydrocarbon group, and it further contains the compound (B) with a functionality of three or more that can react with a phenolic hydroxyl group as an essential ingredient, and therefore suitable results are obtained in all physical properties in good balance, and, particularly, the dimensional stability and the low dielectric properties, and the heat resistance and the low dissipation factor properties, which had been in tradeoff in Comparative examples, were achieved together. This would be because the crosslink density after heat curing increases, and the dimensional stability during hot press and the heat resistance during solder reflow can be imparted by introducing a phenolic hydroxyl group that serves as a cross-linking point on the side chain of the polyamide, which is the feature of the present invention, and using the compound (B) with a functionality of three or more as an essential ingredient. Further, by introducing a part having a C20-60 hydrocarbon group to the polyamide (A), the concentration of an amide bond with high moisture absorption can be lowered, and it is thereby possible to impart the moist heat resistance and obtain the one with good low dielectric properties and low dissipation factor properties as a result.

Further, Example having a branching structure (see Table 11) can improve the dimensional stability and the heat resistance more effectively compared with Example that does not have a branching structure (for example, see Table 10).

## Industrial Applicability

According to the present invention, the phenolic hydroxyl group-containing polyamide and the thermosetting resin composition excellent in having good dimensional stability, adhesiveness, heat resistance, moist heat resistance, electrical insulating properties, flexibility, low dielectric properties and low dissipation factor properties, which are significantly advantageous in achieving the dimensional stability and the dielectric constant together and the adhesiveness and the electrical insulating properties together, particularly, were obtained. Those can be suitably used for an adhesive agent and an adhesive sheet, a coating agent, a solder resist for circuit coating, a coverlay film, an electromagnetic shielding adhesive agent, a plating resist, an interlayer insulating material for a printed-wiring board, an optical waveguide and the like to be used for electronic materials like a printed-wiring board. Especially, the thermosetting resin composition according to the present invention is suitably used for an adhesive composition.

## Claims

1. A thermosetting resin composition containing a polyamide (A) made by polymerization of a polybasic acid monomer and a polyamine monomer and having a phenolic hydroxyl group on a side chain, and a compound (B) with a

functionality of three or more that can react with the phenolic hydroxyl group, wherein
the polyamide (A) satisfies (i) and/or (ii) and further satisfies (iii) to (vi) below, and
the compound (B) satisfies (vii) below:

(i) the polyamide (A) is a polyamide (A-1) containing, in the same polymer, the phenolic hydroxyl group and a hydrocarbon group with a carbon number of 20 to 60 (excluding an aromatic ring to which the phenolic hydroxyl group bonds),
(ii) the polyamide (A) is a polyamide (A-3) being a mixture of a polyamide (a-1) containing a phenolic hydroxyl group on a side chain and a polyamide (a-2) containing a hydrocarbon group with a carbon number of 20 to 60,
(iii) monomers that form the polyamide (A-1) include a monomer having a phenolic hydroxyl group and a monomer having a hydrocarbon group with a carbon number of 20 to 60,
(iv) the polybasic acid monomer or/and the polyamine monomer that form the polyamide (a-1) include a monomer having a phenolic hydroxyl group, and the polybasic acid monomer and the polyamine monomer do not include a monomer having a hydrocarbon group with a carbon number of 20 to 60,
(v) the polybasic acid monomer or/and the polyamine monomer that form the polyamide (a-2) include a monomer having a hydrocarbon group with a carbon number of 20 to 60, and the polybasic acid monomer and the polyamine monomer do not include a monomer having a phenolic hydroxyl group,
(vi) at least a part of monomers having a hydrocarbon group with a carbon number of 20 to 60 includes a compound having a cyclic structure with a carbon number of 5 to 10, and
(vii) the compound (B) is at least one selected from a group consisting of an epoxy group-containing compound, an isocyanate group-containing compound, a carbodiimide group-containing compound, metal chelate, metal alkoxide and metal acylate.

**2.** The thermosetting resin composition according to Claim 1, wherein at least two selected from a group consisting of an epoxy group-containing compound, an isocyanate group-containing compound, a carbodiimide group-containing compound, metal chelate, metal alkoxide and metal acylate are used in combination as the compound (B).

**3.** The thermosetting resin composition according to Claim 1 or 2, wherein a phenolic hydroxyl value of the polyamide (A) is 1 to 80 mgKOH/g.

**4.** The thermosetting resin composition according to any one of Claims 1 to 3, wherein 10 to 95 mol% of monomers having a hydrocarbon group with a carbon number of 20 to 60 are contained in 100 mol% of all monomers that form the polyamide (A).

**5.** The thermosetting resin composition according to any one of Claims 1 to 4, wherein the monomer having a hydrocarbon group with a carbon number of 20 to 60 is a monomer containing, as a residue, a dimer derived from a monobasic unsaturated fatty acid with a carbon number of 10 to 24.

**6.** The thermosetting resin composition according to any one of Claims 1 to 5, wherein a glass-transition temperature of the polyamide (A) is -40° to 120°C.

**7.** The thermosetting resin composition according to any one of Claims 1 to 6, wherein a mass-average molecular weight of the polyamide (A-1) is 3,000 to 1,000,000.

**8.** The thermosetting resin composition according to any one of Claims 1 to 7, wherein a mass-average molecular weight of the polyamide (a-2) is 3,000 to 1,000,000.

**9.** The thermosetting resin composition according to any one of Claims 1 to 8, wherein a mass-average molecular weight of the polyamide (a-1) is 500 to 30,000.

**10.** The thermosetting resin composition according to any one of Claims 1 to 9, wherein an epoxy group-containing compound, and at least one selected from a group consisting of metal chelate, metal alkoxide and metal acylate are used in combination as the compound (B) with a functionality of three or more that can react with a phenolic hydroxyl group.

**11.** The thermosetting resin composition according to any one of Claims 1 to 10, wherein the polyamide (A) further satisfies (viii) to (ix):

(viii) a part of monomers having a hydrocarbon group with a carbon number of 20 to 60 contained as monomers that form the polyamide (A-1) is at least one of a polybasic acid compound with a functionality of three or more and a polyamine compound with a functionality of three or more, and
(ix) a part of monomers having a hydrocarbon group with a carbon number of 20 to 60 contained as monomers that form the polyamide (a-2) is at least one of a polybasic acid compound with a functionality of three or more and a polyamine compound with a functionality of three or more.

**12.** A polyamide (A-1) made by polymerization of a polybasic acid monomer and a polyamine monomer and having a phenolic hydroxyl group on a side chain, wherein
the phenolic hydroxyl group and a hydrocarbon group with a carbon number of 20 to 60 (excluding an aromatic ring to which the phenolic hydroxyl group bonds) are contained in the same polymer, and
the polyamide (A-1) is made by polymerization of monomers including a monomer having a phenolic hydroxyl group and a monomer having a hydrocarbon group with a carbon number of 20 to 60 and having a cyclic structure with a carbon number of 5 to 10.

**13.** The polyamide (A-1) according to Claim 12, wherein a phenolic hydroxyl value is 1 to 80 mgKOH/g.

**14.** The polyamide (A-1) according to Claim 12 or 13, wherein 10 to 95 mol% of monomers having a hydrocarbon group with a carbon number of 20 to 60 are contained in 100 mol% of all monomers.

**15.** The polyamide (A-1) according to any one of Claims 12 to 14, wherein a glass-transition temperature is -40° to 120°C.

**16.** The polyamide (A-1) according to any one of Claims 12 to 15, wherein a mass-average molecular weight is 3,000 to 1,000,000.

**17.** The polyamide (A-1) according to any one of Claims 12 to 16, wherein a part of monomers having a hydrocarbon group with a carbon number of 20 to 60 is at least one of a polybasic acid compound with a functionality of three or more and a polyamine compound with a functionality of three or more.

**18.** An adhesive sheet formed from the thermosetting resin composition according to any one of Claims 1 to 11.

**19.** A cured material obtained by heat curing the thermosetting resin composition according to any one of Claims 1 to 11.

**20.** The cured material according to Claim 19, wherein a glass-transition temperature is -40° to 150°C.

**21.** A printed-wiring board comprising a layer made of the cured material according to Claim 19 or 20 arranged on a substrate.

## INTERNATIONAL SEARCH REPORT

International application No.
PCT/JP2014/003517

A. CLASSIFICATION OF SUBJECT MATTER
*C08G69/26*(2006.01)i, *C08L77/06*(2006.01)i

According to International Patent Classification (IPC) or to both national classification and IPC

B. FIELDS SEARCHED

Minimum documentation searched (classification system followed by classification symbols)
C08G69/00-69/50, C08L1/00-101/14

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2002-080591 A (Kuraray Co., Ltd.), 19 March 2002 (19.03.2002), claims; paragraphs [0014], [0016], [0031] (Family: none) | 12-17<br>1-9,11,18-20<br>10,21 |
| Y | JP 2011-038607 A (The Yokohama Rubber Co., Ltd.), 24 February 2011 (24.02.2011), claims; paragraphs [0005], [0007], [0010], [0015] to [0021], [0030] (Family: none) | 1-9,11,18-20 |
| A | JP 09-235371 A (Tomoegawa Paper Co., Ltd.), 09 September 1997 (09.09.1997), entire text (Family: none) | 1-21 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 29 September, 2014 (29.09.14) | 07 October, 2014 (07.10.14) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2014/003517

C (Continuation). DOCUMENTS CONSIDERED TO BE RELEVANT

| Category* | Citation of document, with indication, where appropriate, of the relevant passages | Relevant to claim No. |
|---|---|---|
| A | JP 2003-277508 A (Sumitomo Bakelite Co., Ltd.), 02 October 2003 (02.10.2003), entire text (Family: none) | 1-21 |
| A | JP 2002-097267 A (Nippon Kayaku Co., Ltd.), 02 April 2002 (02.04.2002), entire text (Family: none) | 1-21 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP H11228932 B
- JP H5295342 B
- WO 199957170 A
- JP H6181239 B
- JP H11260864 B
- JP H6338681 B
- JP H6322348 B
- JP H10183076 B
- JP 2006152015 A
- WO 2007052523 A
- JP H9115966 B